# EUROPEAN PATENT APPLICATION

(11) **EP 1 020 897 A1**
(43) Date of publication of application: **19.07.2000**
(21) Application number: 98940553.5
(22) Date of filing: 26.08.1998
(51) Int. Cl.: H01L 21/027, G03F 7/20

(54) **ALIGNER, EXPOSURE METHOD, METHOD OF PRESSURE ADJUSTMENT OF PROJECTION OPTICAL SYSTEM, AND METHOD OF ASSEMBLING ALIGNER**

(30) Priority: 26.08.1997 JP 22951997; 13.02.1998 JP 3186898; 17.07.1998 JP 20248298
(71) Applicant: Nikon Corporation, Tokyo 100-0005 (JP)
(72) Inventor: TANAKA, Yasuaki, Nikon Corporation, Chiyoda-ku, Tokyo 100-0005 (JP); NISHIKAWA, Jin, Nikon Corporation, Chiyoda-ku, Tokyo 100-0005 (JP); AKAGAWA, Katsuyuki, Nikon Corporation, Chiyoda-ku, Tokyo 100-0005 (JP); MIYAKE, Toshihiro, Nikon Corporation, Chiyoda-ku, Tokyo 100-0005 (JP)
(74) Representative: Read, Matthew Charles
(86) International application number: JP9803785
(87) International publication number: WO9910917

(57) **Abstract**

An aligner in which exposure light from an exposure light source (100) is applied to a reticle (R) through an illuminating optical system (200) and its pattern image is projected onto a photosensitive wafer (W) through a projection optical system (300), and which is equipped with a gas supply device (150) for filling spaces (310, 311) formed between optical elements in a lens barrel (LB) housing the projection optical system (300) therein with an inert gas, pressure sensors (PS2, PS3) for sensing the pressures in the spaces, and optical performance adjustment devices (303, 304) for adjusting the optical performance of the projection optical system (300). The optical performance adjustment device refers to a device for adjusting a distance between a pair of the optical elements or a device for adjusting a pressure in a space between the optical elements.

## Description

### INCORPORRATION BY REFERENCE

The disclosures of the following priority applications are herein incorporated by reference: Japanese Patent Application No.H9-229519 filed August 26,1997 Japanese Patent Application No.H10-31868 filed February 13,1998 Japanese Patent Application No.H10-202482 filed July 17,1998

### TECHNICAL FIELD

The present invention relates to an exposure technology employed in a lithography process implemented to manufacture a semiconductor device, a liquid crystal display device and the like, i.e., a process for manufacturing a semiconductor integrated circuit. More specifically, it is preferable in application in an exposure apparatus that uses exposure light advancing within an atmosphere replaced by an inert gas.

### BACKGROUND ART

Exposure apparatuses that expose a photosensitive substrate with an image of a pattern at a reticle (such as a photo-mask) via a projection optical system are employed in a lithography process implemented for manufacturing a semiconductor device, a liquid crystal substrate or the like. In recent years, the development of semiconductor integrated circuits has been oriented toward further miniaturization, and a reduction in the wavelength of the exposure light emitted by a lithography light source has been proposed as a means for achieving further miniaturization that may be adopted in the lithography process.

At present, exposure apparatuses utilizing a KrF excimer laser having a wavelength of 248nm as the stepper light source have already been developed. In addition, a harmonic of a variable wavelength laser such as a Ti-sapphire laser, a quadruple harmonic of a YAG laser having a wavelength of 266nm, a quintuple harmonic of a YAG laser having a wavelength of 213nm, a mercury lamp capable of outputting light having a wavelength of approximately 220nm or a wavelength of 184nm, an ArF excimer laser outputting light having a wavelength of 193nm and the like are attracting interest as promising candidates for short wavelength light sources.

In exposure apparatuses that use e line (wavelength λ = 546nm), g line(λ = 436nm) or i line(λ = 365nm) or employ as their light source a KrF excimer laser or a mercury lamp capable of emitting light having a wavelength of approximately 250nm, the emission spectral line of the light source does not overlap the oxygen absorption spectral area and, consequently, the degree of efficiency in light utilization is not lowered due to oxygen absorption and no problems attributable to generation of ozone caused by oxygen absorption occur. Thus, it is basically possible to perform exposure within a normal atmosphere when these exposure apparatuses are employed.

However, since the emission spectral line of a light source such as an ArF excimer laser overlaps the oxygen absorption spectral area, efficiency in light utilization is reduced due to oxygen absorption and problems attributable to the generation of ozone caused by oxygen absorption occur. For instance, assuming that the transmittance of ArF excimer laser light within a vacuum or an inert gas such as nitrogen or helium is 100%/m, the transmittance becomes lower in the normal atmosphere to approximately 90%/m in a free run state (a natural light emission state) i.e., when an ArF wide-band laser is employed and to approximately 98%/m, even when an ArF narrow-band laser having a narrow spectral bandwidth and dissociated from the oxygen absorption line is employed.

The reduction in transmittance is assumed to be attributable to absorption of the light by oxygen and the ozone that is generated. The generation of ozone not only adversely affects the transmittance (efficiency of light utilization) but also causes deterioration in performance of the exposure apparatus due to its reaction with the surfaces of the optical materials and other parts and environmental contamination.

For this reason, in an exposure apparatus employing an ArF excimer laser as the exposure light source, the air inside the optical systems such as the illuminating optical system and the projection optical system having the light path for the exposure light needs to be replaced with a gas such as nitrogen, helium or the like achieving a low attenuation factor relative to the ArF excimer laser light, i.e., a gas that allows hardly any ArF excimer laser light to become attenuated. It is known that an exposure apparatus having a light source such as an ArF excimer laser needs to have the entire light path filled with an inert gas such as nitrogen in order to prevent the light transmittance from becoming lower and to avoid generation of ozone (e.g., Japanese Laid-Open Patent Publication No.H6-260385).

In addition, it is a well known fact that fluctuations in the pressure in a clean room where a projection exposure apparatus is installed, fluctuations in the temperature of the optical lenses constituting the projection optical system and the like affect the optical performance and cause fluctuations in the magnification factor, the aberration, the focal point and the like. As a solution, projection exposure apparatuses that adjust the optical performance by measuring the energy of the exposure light irradiated at the projection optical system and estimating fluctuation in the optical performance based upon the energy thus measured, such as that disclosed in Japanese Laid-Open Patent Publication No.S60-78454, have been known. Such a projection exposure apparatus in the prior art is provided with an airtight chamber within the projection optical system and a pressure adjustment mechanism which adjusts its internal pressure, in order to suppress fluctuations in the image formation characteristics such as the magnification factor at the projection optical system attributable to fluctuations in the atmospheric pressure.

### DESCLOSURE OF INVENTION

The following is problems of the prior art technology described above.
(1) With regard to the conventional apparatus disclosed in Japanese Laid-Open Patent Publication No. S60-78454, no consideration is made that an inert gas such as nitrogen gas may be forcibly charged to fill the lens barrel of the projection optical system. Thus, in a projection exposure apparatus in which nitrogen gas or an inert gas is charged in the lens barrel of the projection optical system, as disclosed in Japanese Laid-Open Patent Publication No. H6-260385, fluctuations may occur in the magnification factor, the aberration and the focal point due to fluctuations in the pressure in the lens barrel. Thus the projection exposure with the high accuracy may not be performed even if the optical performance is adjusted based upon fluctuations in the atmospheric pressure or the level of energy irradiated at the optical elements. A similar problem exists with respect to the illuminating optical system as well, and there is an added concern that fluctuations in the pressure in the casing of the illuminating optical system may cause uneven illumination distribution.
(2) In the conventional apparatus disclosed in Japanese Laid-Open Patent Publication No. S60-78454, the device that adjusts the internal pressure is bound to become complicated if nitrogen gas or the like achieving a specific pressure level is continuously supplied as described above.
(3) If an inert gas such as nitrogen is continuously supplied by a gas supply device at a specific supply pressure to fill the inside of the optical systems such as the illuminating optical system and the projection optical system having the light path of the exposure light, the internal pressure at the optical systems may rise to an abnormal level due to a failure in the valve on the discharge side or the like while the nitrogen gas is being supplied, which, in turn, may cause damage to the optical systems.

A first object of the present invention is to provide a projection exposure apparatus whose optical performance is not affected by fluctuations in the pressure in the lens barrel of the projection optical system and the pressure inside the casing of the illuminating optical system which are filled with a specific gas such as an inert gas and a method of assembling thereof.

A second object of the present invention is to provide an exposure apparatus in which the internal pressure in the optical systems can be prevented from rising to an abnormally high level during supply of the specific gas with a high degree of reliability.

A third object of the present invention is to provide an exposure apparatus that allows the pressure in an airtight chamber within the projection optical system to be adjusted after the atmosphere in the airtight chamber is replaced with a specific gas and a method of adjusting pressure in the projection optical system.

The exposure apparatus according to the present invention, which comprises an optical system that projects an image of a pattern at an original illuminated by exposure light emitted by an exposure light source onto an object to be exposed, comprises a gas supply device that fills space formed between optical elements inside a housing member that houses the optical system, a pressure sensor that detects the pressure within the space and an optical performance adjustment device that adjusts the optical performance of the optical system in correspondence to the pressure detected by the pressure sensor.

The specific gas includes gasses in which illuminating beams (KrF excimer laser light, ArF excimer laser light, F2 excimer laser light and the like) are not absorbed to any great extent, and more specifically from nitrogen (N2), helium (He), argon (Ar), neon (Ne) and the like.

In case that the optical system is a projection optical system that projects the image of the pattern at the original illuminated by an illuminating optical system onto the object, the gas supply device is a lens barrel gas supply / discharge device that fills space formed between optical elements inside a lens barrel housing the projection optical system with an inert gas, the pressure sensor is a lens barrel internal pressure sensor that detects the pressure within the lens barrel space and the optical performance adjustment device is a projection optical performance adjustment device that adjusts the optical performance of the optical system in conformance to the pressure detected by the lens barrel internal pressure sensor.

The exposure apparatus also comprises the illuminating optical system that illuminates the original having a specific pattern formed therein with exposure light emitted by the exposure light source, as well as the projection optical system. In this case, the gas supply device further includes a casing gas supply / discharge device that fills the space formed between optical elements inside the housing that houses the illuminating optical system with an inert gas, the pressure sensor further includes a casing internal pressure sensor that detects the pressure inside the casing space and the optical performance adjustment device further includes an illumination optical performance adjustment device that adjusts the optical performance of the illuminating optical system in correspondence to the pressure detected by the casing internal pressure sensor.

In an exposure apparatus as described above, by providing a casing such as the casing or the lens barrel at, at least part of the illuminating optical system, the light transmission system or the projection optical system into which the inert gas is supplied, the atmosphere in which the exposure light travels inside the casing is replaced by the inert gas to prevent the generation of ozone. As a result, the projection exposure apparatus is allowed to perform in a stable manner by preventing clouding of the surfaces of the optical elements such as lenses, without compromising the environment or lowering the degree of light utilization efficiency. According to the present invention, in the exposure apparatus, in which fluctuations in transmittances and reflectances of the optical elements are prevented by filling the space formed between the optical elements with an inert gas, the pressure within the space is detected and the optical performance of the optical system is adjusted in conformance to the pressure thus detected. Consequently, even when the pressure within the space fluctuates, any uneven illumination can be prevented. As a result, fluctuations in various types of image formation performance are minimized and in turn the image of a pattern can be exposed on the object with a high degree of accuracy.

The present invention may be adopted only in the illuminating optical system. In such a case, the gas supply device is a casing gas supply / discharge device that fills space formed between optical elements inside a casing that houses the illuminating optical system with an inert gas, the pressure sensor is a casing internal pressure sensor that detects the pressure within the casing space and the optical performance adjustment device is an illumination optical performance adjustment device that adjusts the optical performance of the illuminating optical system in correspondence to the pressure detected by the casing internal pressure sensor.

The exposure apparatus may further comprises an atmospheric pressure sensor that detects the atmospheric pressure so that the optical performance of the projection optical system can be adjusted by the projection optical performance adjustment device based upon the internal pressure within the lens barrel space and the atmospheric pressure. Alternatively, the illumination optical performance adjustment device may be employed to adjust the optical performance of the illuminating optical system based upon the internal pressure in the casing space and the atmospheric pressure.

Since the optical performance of an optical system is adjusted based upon the internal pressure in the space and the atmospheric pressure, an uneven illumination can be prevented with a higher degree of accuracy and it is possible to achieve a high degree of accuracy in the pattern exposure by minimizing fluctuations in various types of image formation performance, even when the atmosphere between the projection optical system and the object cannot be replaced with inert gas and the optical performance is adversely affected by fluctuations in the atmospheric pressure in the optical path or when the atmosphere between the exposure light source and the illuminating optical system cannot be replaced by an inert gas and the optical performance of the illuminating optical system is adversely affected by fluctuations in the atmospheric pressure in the optical path.

The optical performance adjustment device described above may be constituted as a pressure adjustment device that adjusts the pressure in the space so that it would achieve a preset target value, in correspondence to the pressure detected by the pressure sensor, resulting in a high degree of accuracy in exposure of the object with a pattern image by minimizing the fluctuations in the optical performance attributable to fluctuations in the pressure within the space. By detecting the pressure inside the casing space and controlling it to achieve a target value, an uneven illumination can be prevented, which in turn, prevents any reduction in the exposure accuracy attributable to the uneven illumination.

While an atmospheric pressure sensor that detects the atmospheric pressure may be provided in such a case, it is more desirable to separately provide a projection optical performance adjustment device that adjusts the optical performance of the projection optical system based upon the internal pressure within the lens barrel space and the atmospheric pressure or an illumination optical performance adjustment device that adjusts the optical performance of the illuminating optical system based upon the internal pressure within the casing space and the atmospheric pressure.

In addition, by detecting the atmospheric pressure and adjusting the optical performance of the illuminating optical system in correspondence to the detected atmospheric pressure in the projection exposure apparatus, an uneven illumination caused by fluctuations in the atmospheric pressure can be prevented, even when the optical path extending from the exposure light source to the illuminating optical system is exposed to the atmosphere.

A plurality of optical elements are provided to form space inside the housing member, and the optical performance adjustment device may include a moving mechanism which causes, at least, a first optical element among the plurality of optical elements to move relative to a second optical element along a specific direction.

Normally, a plurality of optical elements are provided to form the space inside the housing member and, at least, the first optical element among the plurality of optical elements moves relative to the second optical element along the specific direction by the moving mechanism. In this exposure apparatus, the first optical element is held by a first holding member and the second optical element is held by a second holding member. It is desirable to provide a sealing portion between the first holding member and the second holding member to prevent the specific gas from flowing out through the space formed between the optical elements. The sealing portion may be constituted of an indented portion formed toward the first holding member, a projected portion formed toward the second holding member, which is inserted within the indented portion and a filler material that fills the space between the indented portion and the projected portion and has a sealing property. The preferable filler material is an inert grease that is photochemically inert.

Since the sealing portion has a structure achieved by filling the space between the indented portion and the projected portion with the filler material, the filler material is present in the space between the inner surface of the indented portion and the outer surface of the projected portion inserted within the indented portion. As a result, when performing adjustment at the lens adjustment portion and the like at the projection optical system, for instance, the filler material is retained between the inner surface of the indented portion and the outer surface of the projected portion and is less likely to become deformed in the direction perpendicular to the direction of displacement, whereby preventing the two members from becoming displaced relative to the positions achieving a specific relationship to each other. Consequently, when performing adjustment in the projection exposure apparatus, for instance, the projection accuracy does not become lowered and patterns can be overlaid with a high degree of accuracy. By using grease as the filler material, which is a viscous material and does not impart a reactive force large enough to cause the two members to become displaced, the two members constituting the casing do not become displaced relative to the positions achieving a specific relationship even if they are moved relative to each other and therefore a high degree of accuracy can be maintained. Furthermore, since the inert grease is photochemically inert, it does not react photochemically with the inert gas supplied into the casing, and maintains its sealing property.

The exposure apparatus according to the present invention that exposes an object by using an illuminating beam via a mask comprises a gas supply device that supplies a specific gas to an optical system provided within a light path of the illuminating beam, a supply passage which is provided separately from a discharge passage connected to the optical system and connects the gas supply device and the optical system with a branching passage provided in its middle area and a pipeline open/close device that opens the branching passage when the pressure of the specific gas exceeds a predetermined level.

In this structure, the specific gas is supplied to the optical system provided within the light path of the illuminating beam via the supply passage by the gas supply device. If the pressure of the specific gas exceeds a predetermined value while the specific gas is being supplied, the pipeline open/close device opens up the branching passage provided in the middle of the supply passage. Thus, it is possible to prevent the internal pressure at the optical system from rising to an abnormally high level during the supply of the specific gas with a high degree of reliability.

The exposure apparatus according to the present invention that transfers a mask pattern onto an object to be exposed via a projection optical system comprises the projection optical system that is provided with an airtight chamber at, at least, a portion thereof, a gas supply device that supplies a specific gas to the airtight chamber, a discharge passage open/close device that opens / closes a discharge passage connected to the airtight chamber, a gas filling level sensor system that detects the degree to which the airtight chamber has been filled with the specific gas, a pressure adjustment mechanism provided in the middle of a supply passage connecting the airtight chamber and the gas supply device, that increases or decreases the level of pressure inside the airtight chamber, a pressure setting device that sets the pressure in the supply passage while gas being supplied, a first control device that opens the discharge passage open/close device and sets the gas supply pressure to a first value via the pressure setting device prior to a start of supply of the specific gas by the gas supply device and that closes the discharge passage open/close device and sets the gas supply pressure to a second value lower than the first value via the pressure setting device when it is detected by the gas filling level sensor system that the airtight chamber has been filled with the specific gas, and a second control device that starts implementing pressure control within the airtight chamber via the pressure adjustment mechanism after the gas supply pressure is set to the second value.

In this structure, the first control device opens the discharge passage open/close device and sets the gas supply pressure inside the supply passage to the first value via the pressure setting device. Next, the gas supply device starts to supply the specific gas to the airtight chamber via the supply passage. If it is detected by the gas filling level sensor system that the airtight chamber has been filled with the specific gas while the specific gas is being supplied, the first control device closes the discharge passage open/close device and sets the gas pressure to the second value lower than the first value via the pressure setting device. Then, after the gas supply pressure is set to the second value, the second control device starts implementing pressure control within the airtight chamber via the pressure adjustment mechanism. As a result, when supplying the specific gas to fill the airtight chamber in order to replace the air inside the airtight chamber with the specific gas, the gas supply pressure is set at the first value which is high enough that the replacement can be achieved quickly and reliably, whereas when the replacement is completed and the space within the airtight chamber is filled with the specific gas, the gas supply pressure is set to the second value which is suitable for the operation of the pressure adjustment mechanism to ensure that pressure adjustment inside the airtight chamber can be adjusted smoothly to achieve, for instance, the adjustment of the image formation characteristics at the projection optical system.

The method of pressure adjustment according to the present invention employed to adjust the image formation characteristics of a projection optical system by adjusting the internal pressure of an airtight chamber inside the projection optical system with a pressure adjustment mechanism comprises a step in which, prior to the start of pressure control inside the airtight chamber, the supply of a specific gas to the airtight chamber is started with a discharge passage connected to the airtight chamber set to an open state and the gas supply pressure set to a first value and a step in which, when the airtight chamber has been filled with the specific gas, the discharge passage is set to a closed state and the gas supply pressure is set to a second value lower than the first value and within a range that enables operation of the pressure adjustment mechanism.

In this method, before starting the pressure control in the airtight chamber, supply of the specific gas is started in a state in which the discharge passage connected to the airtight chamber is opened and the gas supply pressure is set to the first value. Then, when the airtight chamber has become filled with the specific gas, the discharge passage is closed and the gas supply pressure is set to the second value lower than the first value and within a range that enables the operation of the pressure adjustment mechanism. After the gas pressure is set to the second value, the pressure control is started in the airtight chamber to achieve the adjustment of the image formation characteristics at the projection optical system. As a result, when supplying the specific gas to fill the airtight chamber in order to replace the air inside the airtight chamber with the specific gas, the gas supply pressure is set at the first value which is high enough that the replacement can be achieved quickly and reliably, whereas when the replacement is completed and the space within the airtight chamber is filled with the specific gas, the gas supply pressure is set to the second value which enables the operation of the pressure adjustment mechanism to ensure that pressure adjustment inside the airtight chamber can be adjusted smoothly to achieve the adjustment of the image formation characteristics at the projection optical system.

### BRIEF DESCRIPTION OF THE DRAWINGS

FIG. 1 is a structural diagram of a first embodiment of the projection exposure apparatus according to the present invention;
FIG. 2 is a structural diagram of a second embodiment of the projection exposure apparatus according to the present invention;
FIG. 3 is a structural diagram of a third embodiment of the projection exposure apparatus according to the present invention;
FIG. 4 is a structural diagram of a forth embodiment of the projection exposure apparatus according to the present invention;
FIG. 5 is a structural diagram of a fifth embodiment of the projection exposure apparatus according to the present invention;
FIG. 6 is a longitudinal sectional view of the projection optical system in the projection exposure apparatus according to the present invention;
FIG. 7 is a longitudinal sectional view of another example of the projection optical system in the projection exposure apparatus according to the present invention;
FIG. 8 schematically illustrates the structure of the exposure apparatus in an embodiment of the present invention; and
FIG. 9 is a schematic diagram illustrating the structure of the system supplying nitrogen gas to the projection optical system in the apparatus illustrated in FIG. 8.

### BEST MODE FOR CARRYING OUT THE INVENTION

The following is an explanation of embodiments of the present invention, given in reference to the drawings.

### (First Embodiment)

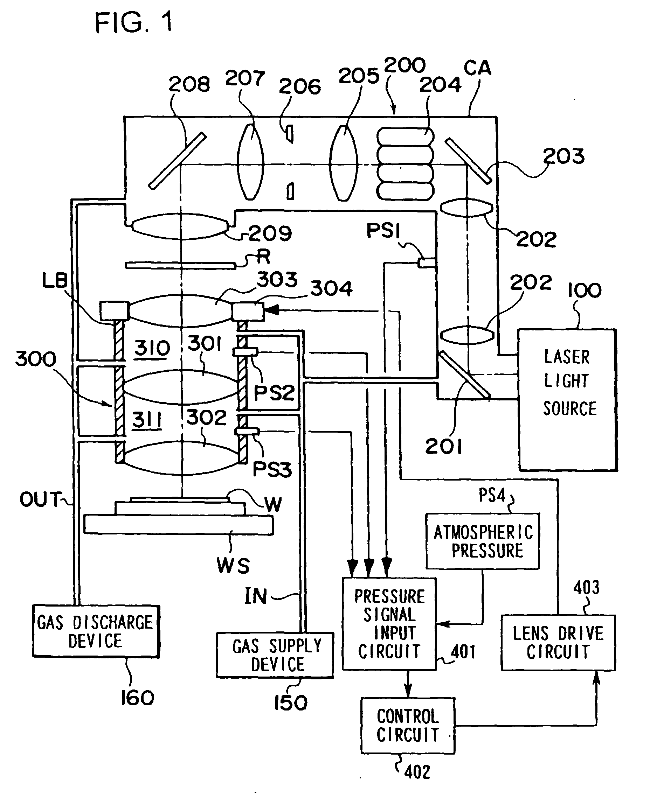

FIG. 1 shows a schematic structure of the projection exposure apparatus according to the present invention. The projection exposure apparatus main unit is housed inside a chamber (not shown) and is controlled to maintain a constant temperature. As illustrated in FIG. 1, laser light which is emitted as a roughly parallel light beam by an ArF excimer laser light source 100 that oscillates pulse light having an output wavelength of, for instance, 193nm enters the projection exposure apparatus via a shutter (not shown). The shutter closes the illuminating light path while the wafer or reticle is replaced, for instance, to cause self oscillation of the light source 100 to stabilize (adjust) the beam characteristics that include, at least, one of; the central wavelength, the wavelength width and the intensity of the pulse light.

The laser light emitted by the light source 100 enters an illuminating optical system 200 housed inside a casing CA via a light transmission system (not shown). The laser light is reflected by a mirror 201 and then enters a beam shaping optical lens unit 202. The beam having entered the beam shaping optical lens unit 202 is shaped to laser light having a specific cross-sectional shape, travels through one of a plurality of ND filters having different transmittances (light reduction rates) from each other that are provided at a turret plate (not shown) to be reflected by a reflecting mirror 203 and then is guided to a fly-eye lens 204 as an optical integrator. The fly-eye lens 204 is constituted by bundling numerous lens elements, and numerous light source images (secondary light sources) whose number corresponds to the number of lens elements are formed at the emission surfaces of the lens elements.

The light fluxes from the numerous secondary light sources formed at the fly-eye lens 204 travel through a relay lens unit 205, a variable field stop 206 that defines a rectangular opening and a relay lens unit 207 to be condensed at a condenser optical lens unit 209 constituted of refractive optical elements such as a plurality of lenses after being reflected by a reflecting mirror 208. Thus, an even illuminating light flux having been defined at the opening 206 of the variable field stop illuminates a reticle R in a superimposing manner.

A gas that does not absorb ArF light such as nitrogen gas (or helium gas) is supplied into the casing CA of the illuminating optical system 200 from a gas supply device 150 via a pipeline IN, and the nitrogen gas is discharged through a pipeline OUT via a gas discharge device 160. The pressure inside the casing CA is detected by a pressure sensor PS1.

The light that has been transmitted through the reticle R reaches the surface of a wafer W mounted on a wafer stage WS via various types of optical members (lens elements and / or mirrors) constituting a projection optical system 300, to form an image of a pattern on the reticle R. The wafer stage WS makes the wafer W move relative to light that originates from the reticle R irradiated with the illuminating light and travels through the projection optical system 300. During an exposure operation, the reticle R and the wafer W are scanned at speeds achieving a speed ratio corresponding to the magnification factor at the projection optical system along directions opposite from each other. The projection optical system 300 is provided with, for instance, two projection lens units 301 and 302 and one optical performance adjustment lens unit 303, and the optical performance of the optical performance adjustment lens unit 303 is adjusted by a lens drive device 304. The lens drive device 304, which is of the known art such as that disclosed in Japanese Laid-Open Patent Publication No. S60-78454, for instance, is capable of adjusting the magnification factor and the like by varying, for instance, the distance between lenses. It is to be noted that a new structure that may be adopted to vary the distance between lenses is to be explained later in reference to the seventh embodiment. The lens units 301 ∼ 303 are enclosed by a lens barrel LB as is the illuminating optical system 200. Nitrogen gas is supplied to the lens barrel LB from the gas supply device 150 via the pipeline IN and the nitrogen gas discharged through the pipeline OUT via the gas discharge device 160.

The pressure in a space 310 formed between the lens units 303 and 301 inside the lens barrel LB is measured by a pressure sensor PS2 and the pressure in a space 311 formed between the lens units 301 and 302 inside the lens barrel LB is measured by a pressure sensor PS3. The atmospheric pressure inside the chamber in which the projection exposure apparatus is housed is measured by an atmospheric pressure sensor PS4. Pressure signals resulting from the measurement performed by the casing internal pressure sensor PS1 mentioned earlier and by the pressure sensor PS2 ∼ PS4 are converted to digital signals at a pressure signal input circuit 401 and are input to a control circuit 402 constituted of a CPU and the like. A lens drive circuit 403 provides the lens drive device 304 with a drive signal based upon a command signal provided by the control circuit 402, so that the lens unit 303 changes its optical performance as appropriate.

The control circuit 402 comprises a memory in which the change in the optical performance of the projection optical system in correspondence to the pressure detected by the individual pressure sensors PS2 ∼ PS4 is stored in advance. The refractive index of the gas is dependent upon the pressure, and fluctuations in the optical performance due to fluctuations in the pressures in the spaces 310 and 311 inside the lens barrel and fluctuations in the optical performance due to fluctuations in the atmospheric pressure inside the chamber are superimposed upon each other to result in a fluctuation in the optical performance of the entire projection optical system 300. Accordingly, fluctuations in the optical performance such as fluctuations in the focal point position, the projection magnification factor and Seidel's five aberrations, are measured in correspondence to specific combinations of the pressures in the spaces 310 and 311 and the atmospheric pressure in an advance test. Then, the specific way in which the optical performance adjustment lens unit 303 should be driven to correct the fluctuations in the optical performance thus measured is ascertained in correspondence to individual optical characteristics through testing or through calculation (simulation). And the drive quantity for the lens drive device 304 that corresponds to the drive quantity of the optical performance adjustment lens unit 303 is stored in the memory for each pressure. It is to be noted that the rates of change occurring in the individual optical characteristics due to changes in the pressure are stored in advance and the drive quantity may be calculated by ascertaining the quantities of change in the optical characteristics successively.

The operation of the projection exposure apparatus structured as described above is now explained.

Prior to an exposure operation, the air inside the casing CA of the illuminating optical system 200 and inside the lens barrel LB of the projection optical system 300 is evacuated by the gas discharge device 160, and when the pressure values measured by the pressure sensors PS1 ∼ PS3 reach a specific value, an outlet-side open/close valve at the gas discharge device 160 is closed. Then, nitrogen gas is supplied by the gas supply device 150 into the casing CA and the lens barrel LB. When the pressure values measured by the pressure sensors PS1 ∼ PS3 reach a specific value, the nitrogen gas supply by the gas supply device 150 is stopped and an intake-side open/close valve is closed. Thus, the casing CA and the lens barrel LB become filled with the nitrogen gas and become sealed.

ArF laser light is irradiated after, for instance, moving the wafer stage WS to set the wafer W at a position that is sufficiently far away from the optical axis of the projection optical system 300 to ensure that the wafer W is not irradiated by the ArF laser. Through the irradiation of the ArF laser light, contaminants adhering to the surfaces of the optical elements constituting the illuminating optical system 200 and the projection optical system 300, the casing CA and the lens barrel LB become peeled and are suspended within the nitrogen gas. By opening the intake-side open/close valve and the outlet-side open/close valve to discharge the nitrogen gas inside the casing CA and the lens barrel LB while performing such irradiation, the contaminants suspended in the gas are discharged to the outside of the casing CA and the lens barrel LB together with the nitrogen gas. Thereafter, while supplying the nitrogen gas, the outlet-side open/close valve is closed first, and then the intake-side open/close valve is closed when the pressure inside the casing CA and the lens barrel LB becomes a predetermined level, so that the space inside the casing CA and the lens barrel LB is sealed. While it is conceivable to sustain nitrogen gas flow at all times without sealing the lens barrel, similar advantages are achieved by adopting a similar method in such a case. Possible causes of pressure changes occurring in this situation include change in the pressure on the supply side and blockage of the piping. In addition, instead of causing the wafer stage WS to recede, a light-blocking plate between the projection optical system 300 and the wafer W may be used.

An exposure area at the wafer W is set at the exposure initial position (scanning exposure start position) via the wafer stage WS and the reticle R is set to the exposure initial position via a reticle stage (not shown). When laser light is emitted by the laser light source 100, even illuminating light achieving a cross sectional shape defined by the reticle blind illuminates a specific area of the reticle R. The wafer W is exposed with an image of a pattern on the reticle R projecting onto the wafer W while moving the reticle R and the wafer W relative to each other. During this process, the pressure sensor PS2 and PS3 measure the pressures in the spaces 310 and 311 in the lens barrel, the atmospheric pressure sensor PS4 measures the atmospheric pressure inside the chamber and the measurement values are input to the control circuit 402. The control circuit 402 reads out a drive quantity for the lens drive device 304 stored in advance in accordance with the combination of the three pressure thus input, and outputs a lens drive command signal corresponding to the drive quantity to the lens drive circuit 403. In response, the lens drive circuit 403 drives the lens drive device 304 so that the optical performance adjustment lens unit 303 is adjusted to achieve a predetermined optical performance for the projection optical system. Thus, the optical performance of the projection optical system does not fluctuate even when the individual pressure are caused to fluctuate by the exposure energy, to achieve pattern exposure at a predetermined degree of accuracy.

### (Second Embodiment)

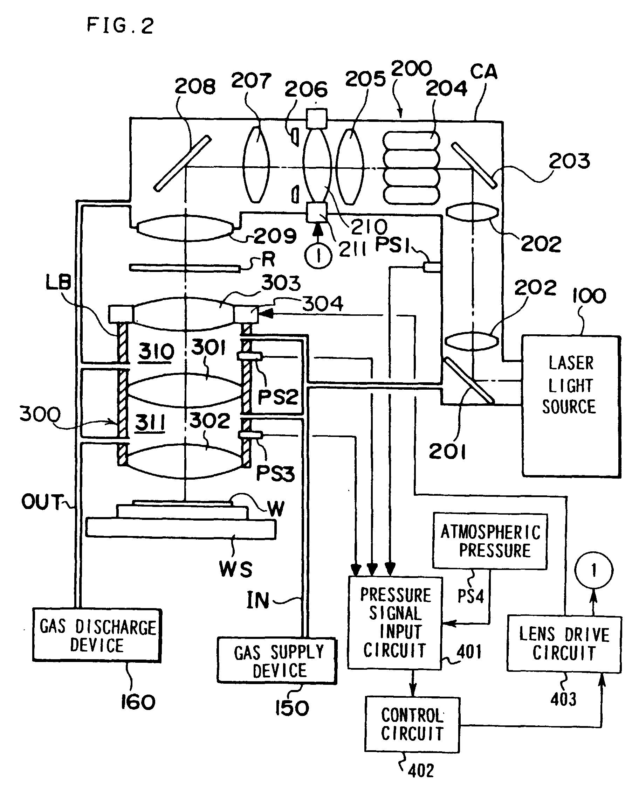

While only the optical performance of the projection optical system 300 is corrected in the previous embodiment, the optical performance of the illuminating optical system 200 may be corrected in correspondence to the pressure inside the casing CA since fluctuations in the pressure inside the casing CA of the illuminating optical system 200 sometimes cause an uneven illumination. In such a case, an optical performance adjustment lens unit 210 may be provided between, for instance, the fly-eye lens unit 204 and a reticle blind 206 to drive the optical performance adjustment lens unit 210 with a lens drive device 211 in correspondence to the pressure in the casing CA, as illustrated in FIG. 2.

The uneven illumination caused by fluctuations in the optical performance of the illuminating optical system 200 is ascertained in correspondence to varying levels of pressure inside the casing CA through testing, a drive quantity for the lens drive device 211 required to minimize the uneven illumination is ascertained through testing or calculation. Then they are stored in the memory at the control circuit 402 in correspondence to the individual pressure levels. It is to be noted that other structural features are similar to those shown in FIG. 1 and that their explanation is omitted.

While the explanation of the procedure taken in the exposure processing at the projection exposure apparatus in the second embodiment structured as described above is similar to the procedure implemented in the first embodiment and, therefore, its explanation is omitted. In the second embodiment, the lens drive device 211 drives the optical performance adjustment lens unit 210 in correspondence to the pressure inside the casing CA. Therefore poor exposure onto a wafer with a pattern image due to an uneven illumination are prevented. It is to be noted that if the light path extending between the laser light source 100 and the casing CA of the illuminating optical system 200 is exposed to the atmosphere, the atmospheric pressure inside the chamber may be detected so that the optical performance adjustment lens unit 210 can be driven by the lens drive device 211 in correspondence to the atmospheric pressure, whereby preventing an uneven illumination from occurring due to fluctuations in the atmospheric pressure, as well.

In the projection exposure apparatus according to the second embodiment, the optical performance adjustment lens unit 303 is driven so as to ensure that the optical performance of the projection optical system does not fluctuate even when the pressure inside the lens barrel LB of the projection optical system 300 fluctuates. And also the optical performance adjustment lens unit 210 is driven so as to ensure that the optical performance of the illuminating optical system 200 does not fluctuate even when the pressure inside the casing CA of the illuminating optical system 200 fluctuates. Therefore the optical performance of the projection optical system and the optical performance of the illuminating optical system do not fluctuate even when the pressure inside the casing CA and the lens barrel LB vary by the exposure energy, so that pattern exposure can be carried out at a predetermined degree of accuracy.

### (Third Embodiment)

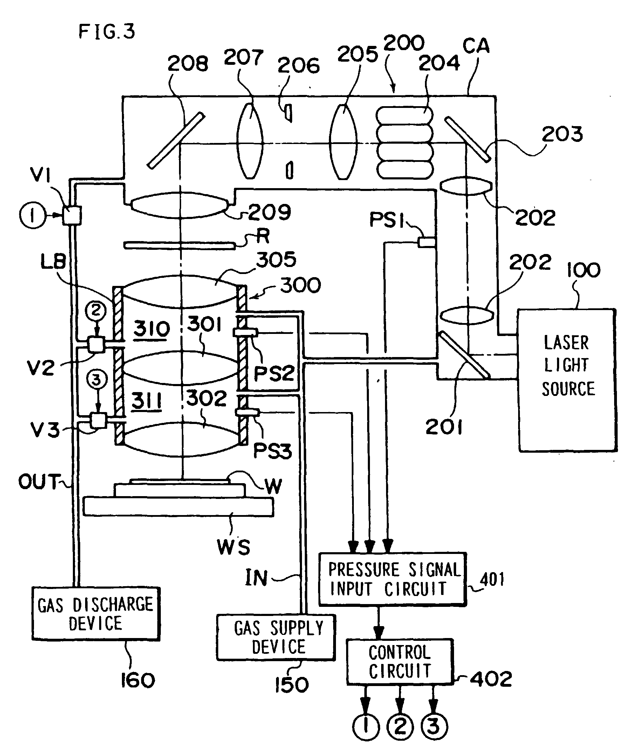

The third embodiment of the projection exposure apparatus according to the present invention is now explained in reference to FIG. 3.

The same reference numbers are assigned to components similar to those in FIGS. 1 and 2 and the explanation will mainly focus on the differences. The projection exposure apparatus in the third embodiment controls the pressure inside the casing CA of the illuminating optical system 200 and the pressure inside the lens barrel LB of the projection optical system 300 at a predetermined target value. Thus, a pressure control valve V1, a pressure control valve V2 and a pressure control valve V3 are respectively provided between the casing CA of the illuminating optical system 200 and the gas discharge device 160, between the space 310 inside the lens barrel LB of the projection optical system 300 and the gas discharge device 160 and between the space 311 and the gas discharge device 160. It is to be noted that the optical performance adjustment lens unit 303 and the lens drive device 304 are omitted in this embodiment, and a lens unit 305 similar to the lens units 301 and 302 is employed.

In the control circuit 402, a pressure target value in design for the pressure inside the casing CA of the illuminating optical system 200 and the design pressure target values in design for the pressures in the spaces 310 and 311 in the lens barrel LB of the projection optical system 300 are stored in advance.

As explained in reference to the first embodiment, prior to an exposure operation, the inside of the casing CA of the illuminating optical system 200 and the space 310 and 311 in the lens barrel LB of the projection optical system 300 are filled with nitrogen gas at a predetermined pressure, and the intake-side open/close valve at the gas supply device 150 and the individual pressure control valves V1 ∼ V3 are closed. The degrees of opening of the pressure control valves V1 ∼ V3 are adjusted to match the pressure detected by the pressure sensors PS1 ∼ PS3 during the exposure processing with the target values stored in the control circuit 402. Thus, the optical performance of the illuminating optical system 200 and the optical performance of the projection optical system 300 become to be values predetermined when these optical systems 200 and 300 are designed, so that pattern exposure at a high degree of accuracy can be carried out. Since the nitrogen gas supply passage to the casing CA and the nitrogen gas supply passage to the lens barrel LB are in communication with each other, it is desirable to isolate the individual nitrogen gas supply passages from each other if the pressure at the casing CA and the pressures in the spaces 310 and 311 are likely to affect each other through the pressure control implemented on the casing CA, and the lens chambers 310 and 311.

### (Fourth Embodiment)

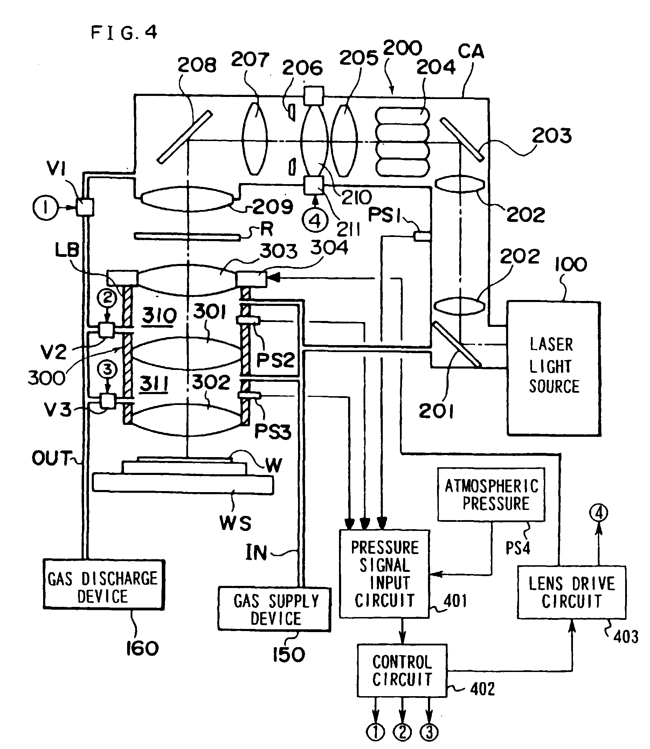

The fourth embodiment of the projection exposure apparatus according to the present invention is now explained in reference to FIG. 4.

The same reference numbers are assigned to components similar to those in FIGS. 1 and 3 and the explanation will mainly focus on the differences. The projection exposure apparatus in the fourth embodiment controls the pressure inside the casing CA of the illuminating optical system 200 and the pressure inside the lens barrel LB of the projection optical system 300 at predetermined target values, as in the third embodiment. And also the pressure sensor PS4 measures the atmospheric pressure and the optical performance of the illuminating optical system 200 and the optical performance of the projection optical system 300 are adjusted in conformance to the atmospheric pressure. Accordingly, the optical performance adjustment lens unit 210 and its drive device 211 are provided at the illuminating optical system 200 and the optical performance adjustment lens unit 303 and its drive device 304 are provided at the projection optical system 300, as in the first embodiment.

In the projection exposure apparatus in the fourth embodiment as described above, the pressure inside the casing CA and the lens barrel LB are controlled at the target values. As a result, any reduction in the accuracy of exposure from occurring due to the pressure of the inert gas filled inside the casing CA and the lens barrel LB can be prevented. Also, the optical performance adjustment lens units 210 and 303 correct fluctuations in the optical performance occurring due to fluctuations in the atmospheric pressure. Therefore the exposure accuracy can be improved.

### (Fifth Embodiment)

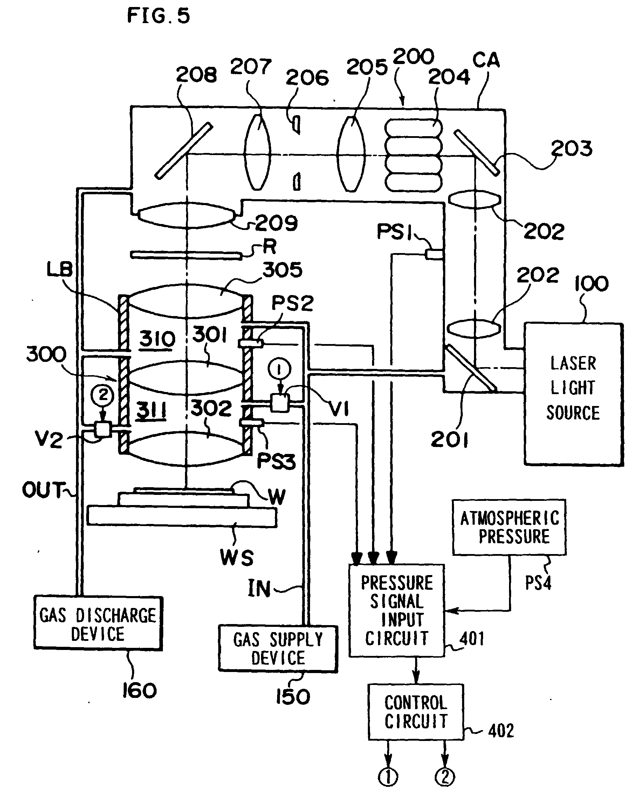

The fifth embodiment of the projection exposure apparatus according to the present invention is now explained in reference to FIG. 5.

The same reference numbers are assigned to components similar to those in FIG. 1 and the differences are explained. In the projection exposure apparatus according to the first embodiment, the optical performance of the projection optical system 300 is adjusted through drive control implemented on the optical performance adjustment lens unit 303. However the fifth embodiment, the pressure of the nitrogen gas in the space 311 between the lens units 301 and 302 is varied so as to adjust the optical performance of the projection optical system.

As illustrated in FIG. 5, among the plurality of space (the space 310 and 311 in FIG. 5) formed inside the lens barrel LB of the projection optical system 300, the space 311 is used as a control target chamber. Namely, a pressure control valve V1 is provided between the space 311 and the gas supply device 150 and a pressure control valve V2 is provided between the space 311 and the gas discharge device 160. In addition, optical performance (the focal point position, the projection magnification factor and the like) achieved through different combinations of the pressures in the spaces 310 and 311 inside the lens barrel and the atmospheric pressure ascertained in advance through testing or calculation (simulation) are stored at the control circuit 402 in correspondence to individual sets of pressure control data for controlling the pressure in the space 311 to correct fluctuations in the optical performance.

It is to be noted that the pressure control data described above may be calculated by storing in advance rates of change in individual optical characteristics occurring due to pressure changes and obtaining the change quantity in a given type of optical characteristics successively.

As explained earlier in reference to the first embodiment, prior to an exposure operation, the air inside the casing CA of the illuminating optical system 200 and inside the lens barrel LB of the projection optical system 300 is discharged by the gas discharge device 160. When the pressure values measured by the pressure sensors PS1 ∼ PS3 each reach a predetermined value, an outlet-side open/close valve at the gas discharge device 160 is closed. Then, nitrogen gas is supplied by the gas supply device 150 into the casing CA and the lens barrel LB. When the pressure values measured by the pressure sensors PS1 ∼ PS3 reach a predetermined value, the nitrogen gas supply by the gas supply device 150 is stopped and an intake-side open/close valve is closed and also the pressure control valves V1 and V2 are closed. Thus, the casing CA and the lens barrel LB are filled with the nitrogen gas. It is to be noted that in this embodiment, it is acceptable that the space 311 is used as an airtight chamber filled with nitrogen gas and the casing CA and the space 310 in the lens barrel LB remain unsealed allowing nitrogen gas to flow through them at all times.

Next, exposure processing starts. During the exposure processing, the individual pressure sensors PS2 ∼ PS4 measure the pressure and input the measurement values to the control circuit 402. The control circuit 402 reads out pressure control data for implementing pressure control in the space 311 stored in advance in accordance with the combination of the measurement values from the individual pressure sensors thus input. Then, based upon the pressure control data that have been read out, the control circuit 402 implements nitrogen gas pressure control by adjusting the degrees of opening of the pressure control valves V1 and V2 to change the pressure in the space 311. For instance, the pressure in the space 311 is raised by closing the pressure control valve V2 and opening the pressure control valve V1 to allow nitrogen gas from the gas supply device 150 to flow into the space 311. The pressure in the space 311 can be lowered, on the other hand, by opening the pressure control valve V2 and closing the pressure control valve V1. Through such pressure control, the optical performance (e.g., the projection magnification factor) of the projection optical system can be adjusted to a predetermined performance even when a pressure change (a pressure difference between the gas pressure inside the lens barrel LB and the atmospheric pressure) occurs inside the lens barrel LB. Thus, the optical performance of the projection optical system does not fluctuate even when the pressure inside the lens barrel LB fluctuates, so that pattern exposure can be carried out with a predetermined degree of accuracy.

It is to be noted that the embodiment may be provided with a pressure control valve between the space 310 and the gas supply device 150 and a pressure control valve between the space 310 and the gas discharge device 160, to be utilized for evacuation and preparation of a nitrogen gas atmosphere at a specific pressure. If a pressure fluctuation occurs in the space 310 as an airtight chamber, the pressure in the space 311 is controlled to adjust the optical performance of the projection optical system.

In addition, an optimal space to be used as a pressure control chamber in which a pressure is controlled is selected through simulation, testing or the like. For instance, it is desirable to determine the pressure control chamber as follows. Changes in the relative refractive index with respect to the space between lenses constituting the optical system designed in correspondence to the wavelength of the exposure light are measured while varying a pressure in that space and then the space achieving the least change is designated as the pressure control chamber. In addition, spaces designated as pressure control chambers may be provided at a plurality of locations.

While the explanation of the embodiment has been made with respect to the projection optical system 300, a pressure control chamber may be provided at the illuminating optical system 200 to correct the optical performance of the illuminating optical system 200. In such a case, a space formed by the lens 205 and a lens (not shown) between the fly-eye lens unit 204 and the reticle blind 206 may be designated as a pressure control chamber. Then, in correspondence to the pressure inside the casing CA, the uneven illumination attributable to fluctuations in the optical performance of the illuminating optical system 200 may be ascertained through testing so that pressure control data required to minimize the uneven illumination can be calculated, which can then be stored at the control circuit 402 in correspondence to varying levels of pressure.

It is to be noted that while fluctuations in the optical performance including the optical performance of the projection optical system 300 are suppressed in the individual embodiments explained above, only the optical performance of the illuminating optical system 200 may be corrected as long as a desired degree of accuracy is achieved. In addition, while the explanation is given above on an example in which an ArF excimer laser outputting light with a wavelength of 193nm is utilized as an exposure light source, the present invention may be adopted in any of various types of projection exposure apparatuses that use other types of light sources such as a KrF excimer laser and require an inert gas to fill the casing of the illuminating optical system and the lens barrel of the projection optical system.

Furthermore, when employing the optical performance adjustment lens unit 303 to suppress fluctuations in the optical performance caused by fluctuations in the pressure in the lens barrel LB of the projection optical system 300, a lens unit provided separately from the optical performance adjustment lens unit 303 may be utilized to compensate for fluctuations in the optical performance of the projection optical system caused by fluctuations in the atmospheric pressure. Likewise, a lens unit provided separately from the optical performance adjustment lens unit 210 may be utilized to compensate for fluctuations in the optical performance of the illuminating optical system caused by fluctuations in the atmospheric pressure.

### (Sixth Embodiment)

An explanation will be made on the projection optical unit 300 provided with the optical performance adjustment lens unit 303 explained in the first, second and fourth embodiments. It is a type of structure in which the lens 303 moves relative to the lens 301.

First, a background of the structure is explained. The movement of a lens relative to another lens may cause the inert gas supplied into the lens barrel to leak. For this reason, a packing or a gasket constituted of a rubber material or the like is sandwiched between the holding member that holds one lens and the holding member that holds the other lens to absorb the change in the relative distance between them. However, a packing or a gasket that has a thickness of a specific dimension or larger, constituted of an elastic material such as rubber, may become deformed along the direction perpendicular to the thickness-wise direction as well as along the thickness-wise direction when it becomes clamped by the two holding members. This causes the positional relationship between the two lenses to become displaced along the direction perpendicular to the optical axis relative to the positional relationship that is originally intended and, as a result, adjustment at the adjustment unit may not be achieved with a high degree of accuracy.

In addition, in a structure in which the space between the lenses that move relative to each other is sealed, when the two lenses are made to move relative to each other for adjustment, the volumetric capacity of the space between the two lenses changes to result in a fluctuation in the pressure in the space. For instance, if the lenses are moved in the direction in which they approach each other, the pressure in the space rises, whereas they are moved away from each other, the pressure in the space falls. Such changes in the pressure may cause a change in the refractive index of the atmosphere to result in an unstable image formation position or a distortion of the image.

Thus, the optical performance adjustment optical lens unit provided with the packing or the gasket described above induces a reduction in projection accuracy at the projection exposure apparatus and, as a result, prevent the realization of high accuracy in overlaying patterns.

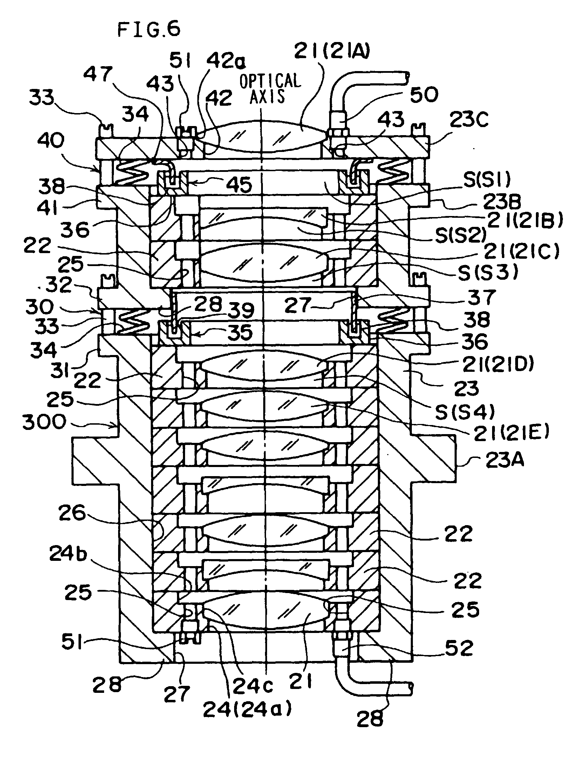

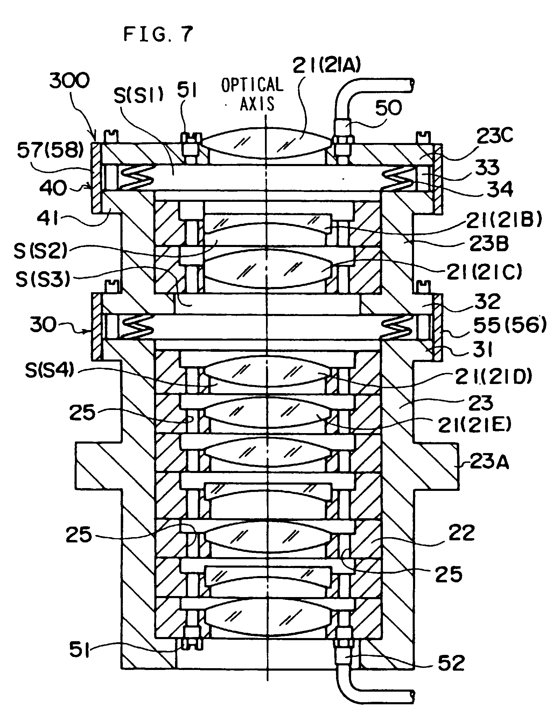

Now, the projection optical system 300 in the embodiment is explained in detail in reference to FIGS. 6 and 7. Structural features other than the projection optical system 300 are identical to those in the first embodiment.

As illustrated in FIG. 6, the projection optical system 300 is constituted of a plurality of lenses, i.e., a plurality of optical elements 21, holding members 22 each holding a lens 21 and a cylindrical lens barrel 23 that houses the holding members 22. The projection optical system 300 condenses the exposure light having been transmitted through the reticle R (see FIG. 1) on the wafer W (see FIG. 1) via the plurality of lenses 21.

At the center of each holding member 22, an opening 24 that communicates with the two sides of the holding member 22 is formed. At the opening 24, formed are a small diameter portion 24a with a diameter smaller than that of the lens 21 and a large diameter portion 24b with a diameter larger than the diameter of the lens 21. The small diameter portion 24a is located at one surface (at the lower surface) of the holding member 22, and the large diameter portion 24b is located at the other surface (the upper surface). A staged portion 24c having a diameter approximately equal to the diameter of the lens 21 is formed between the small diameter portion 24a and the large diameter portion 24b. Each holding member 22 holds the lens 21 by fitting the external circumferential portion of the lens 21 against the staged portion 24c of the opening 24.

At the holding member 22, a plurality of communicating holes 25 that communicate between one surface of the holding member 22 and the other surface where the large diameter portion 24b is formed are formed at the external circumferential side of the small diameter portion 24a of the opening 24.

The lens barrel 23 may be constituted of, for instance, three members, i.e., a lower lens barrel 23A, an upper lens barrel 23B and an upper lid 23C. The internal circumferential surfaces 26 of the lower lens barrel 23A and the upper lens barrel 23B each have an internal diameter that is approximately equal to the external diameter of the holding member 22. At each of the lower ends of the lower lens barrel 23A and the upper lens barrel 23B, an opening 27 having a diameter smaller than the external diameter of the holding member 22 is formed. At the lower ends of the lower lens barrel 23A and the upper lens barrel 23B, these openings 27 form a holding portion 28 that holds the holding members 22 housed therein.

Between the lower lens barrel 23A and the upper lens barrel 23B, an adjustment unit 30 that adjusts their relative positions is provided. The adjustment unit 30 includes a force-applying member 34 provided between a flange 31 formed at the upper end of the lower lens barrel 23A and a flange 32 formed at the lower end of the upper lens barrel 23B and a plurality of adjustment screws 33 employed to adjust the distance between the lower lens barrel 23A and the upper lens barrel 23B. The adjustment screws 33 are rotatably supported by the flange 32, and the threaded portions formed at their front ends are screwed to the flange 31. The force-applying member 34 may include a coil spring having a diameter approximately equal to the diameter of the lens barrel 23 that is provided in a compressed state between the flanges 31 and 32, whereby urging the lower lens barrel 23A and the upper lens barrel 23B in the direction in which they move further away from each other. It is to be noted that three adjustment screws 33, for instance, may be provided over equal angular intervals along the circumference of the flange.

By rotating the adjustment screws 33 at the adjustment unit 30 structured as described above, the relative positions of the flange 31 and the flange 32, i.e., the positions of the lower lens barrel 23A and the upper lens barrel 23B relative to each other, become displaced. In other words, the lower lens barrel 23A and the upper lens barrel 23B are moved relatively along the direction in which they move closer to each other by tightening the adjustment screws 33, whereas the lower lens barrel 23A and the upper lens barrel 23B are moved relatively in the direction in which they move further away from each other by loosening the adjustment screws 33. Thus, the positional relationship between an uppermost lens 21D in the lower lens barrel 23A and the lowermost lens 21C in the upper lens barrel 23B is adjusted. It is to be noted that in FIG. 6, the plurality of lenses 21 constituting the projection optical system 300 are assigned with reference numbers 21A, 21B, 21C ..., starting at the uppermost lens and going toward the lowermost lens.

A sealing portion 35 is provided at the adjustment unit 30 located between the lower lens barrel 23A and the upper lens barrel 23B. The sealing portion 35 comprises a lower ring 36 provided at the upper surface of the holding member 22 housed at the uppermost position in the lower lens 23A, an upper ring, i.e., a projected portion 37, mounted at the opening 27 at the lower end of the upper lens barrel 23B and a sealing material, i.e., a filler material 38, provided between the lower ring 36 and the upper ring 37. At the upper surface of the lower ring 36 which has a cross section formed in a rough U-shape, a groove, i.e., an indented portion 39, is formed. The groove 39 has a diameter approximately equal to the diameter of upper ring 37 and a width greater than the thickness of the upper ring 37 by a predetermined dimension. An inert grease or the like having a property wherein it remains inert to photochemical reaction, for instance, a viscous material such as fluorine grease or a fluorine plastics in a gel state, is used as the sealing material 38. The groove 39 at the lower ring 36 with the sealing material 38 is filled. By inserting the lower end of the upper ring 37 into the sealing material 38, the sealing material 38 is placed between the inner surface of the groove 38 and the outer surface of the upper ring 37 to cut off the communication between the inside and the outside of the lens chamber (space) so that a sealing properties are achieved in the adjustment unit 30.

An adjustment unit 40 having a structure similar to that of the adjustment unit 30 is provided between the upper end of the upper lens barrel 23B and the upper lid 23C which is located above it. The adjustment unit 40 is constituted of a plurality of adjustment screws 33 and a plurality of force-applying members 34 provided between a flange 41 formed at the upper end of the upper lens barrel 23B and the external circumference of the upper lid 23C. By turning the adjustment screws 33, the positions of the upper lens barrel 23B and the upper lid 23C are displaced relative to each other, and the force-applying members 34 apply a force in the direction in which the upper lens barrel 23B and the upper lid 23C move away from each other. By displacing the positions of the upper lens barrel 23B and the upper lid 23C relative to each other with the adjustment unit 40, the positional relationship between the uppermost lens 21B in the upper lens barrel 23B and the lens 21A mounted at the upper lid 23C is adjusted.

An opening 42 having a staged portion 42a at its center for holding the lens 21A is formed at the upper lid 23C and communicating holes 43 are formed on the external circumferential side of the upper lid 23c. The upper lid 23C is a member equivalent to the holding members 22.

The adjustment unit 40 comprises a sealing portion 45 similar to the sealing portion 35. The sealing portion 45 is constituted of a lower ring 36 provided at the upper surface of the holding member 22 housed at the uppermost position in the upper lens barrel 23B, an upper ring having a cross section formed in a approximately L shape, i.e., a projected portion 47, mounted at the lower surface of the upper lid 23C and a sealing material 38 provided between the lower ring 36 and the upper ring 47. The lower end of the upper ring 47 is inserted into the sealing material 38 filling a groove 39 of the lower ring 36, so that the sealing material 38 is placed between the inner surface of the groove 39 and the outer surface of the upper ring 47. As a result, the communication between the inside and the outside of the lens chamber (space) is cut off and sealing properties are achieved at the adjustment unit 40.

Since the communication holes 25 are formed at each of the plurality of holding members 22 housed inside the lens barrel 23 in the projection optical system 300 as described above, spaces that are located at positions vertical relative to each other are formed between two lenses, e.g., a space S1 between the lenses 21A and 21B and a space S3 between the lenses 21C and 21D are in communication with each other. At the upper end portion of the projection optical system 300, a gas supply device (not shown) is connected to one of the communicating holes 43 formed at the upper lid 23C of the lens barrel 23 via a supply pipe 50 through which a gas that is inert with respect to a photochemical reaction such as nitrogen gas or helium gas, and sealing plugs 51 are mounted at other communicating holes 43 to block them off. A gas discharge device (not shown) is connected to one of the communicating holes 25 at the holding member 22 that holds the lens 21 facing opposite the opening 27 at the lower end of the projection optical system 300 via a discharge pipe 52 and other communicating holes 25 are plugged with sealing plugs 51. The inert gas is supplied through the supply pipe 50 into the lens barrel 23, the inert gas is supplied to the individual space S through communicating holes 25 at the holding members 22 and then is discharged through the discharge pipe 52. Thus, the atmosphere in the light path of the exposure light in the lens barrel 23 is replaced with the inert gas and the inert gas is circulated at the projection optical system 300.

In the projection optical system 300 as described above, when an exposure light focal point adjustment and a magnification factor adjustment are carried out, the adjustment screws 33 at the adjustment unit 30 are turned to adjust the positional relationship between the two lenses 21A and 21B positioned above and below the adjustment unit 30. And the adjustment screws 33 at the adjustment unit 40 are turned to adjust the positional relationship between the two lenses 21C and 21D positioned above and below the adjustment unit 40. When the adjustment screws 33 are turned, the lower ring 36 and the upper ring 37 at the sealing portion 35 and the upper ring 47 at the sealing portion 45 are moved relative to each other in the vertical direction. Since the sealing material 38 provided between the rings constituted of an inert grease does not undergo elastic deformation as a packing or a gasket would, it is retained in the state in which it is placed between the side surfaces of the grooves 39 of the lower rings 36 and the side surfaces of the upper rings 37 and 47. Thus, the seal between the lower ring 36 and the upper ring 37 and between the lower ring 36 and the upper ring 47, i.e., the seal at the adjustment units 30 and 40, is maintained.

In a projection exposure apparatus provided with this projection optical system 300, exposure light emitted by the light source 100 irradiates the reticle R via the light transmission system and the illuminating optical system 200, and an image of a circuit pattern formed at the reticle R is projected and a specific exposure area of the wafer W is exposed with the image thus projected via the projection optical system 300, as illustrated in FIG. 1. Then, when the projection exposure of the pattern image onto the exposure area is completed, the stage device WS moves the wafer W to a predetermined position for positioning and a projection operation to expose the next exposure area with the pattern image is performed. The projection exposure of the pattern image onto the entire wafer W is carried out through the so-called step-and-repeat method, in which the movement and positioning of the wafer W and the projection exposure of the pattern image are sequentially repeated in this manner.

As described above, the atmosphere inside the casing CA of the illuminating optical system 200 and the atmosphere inside the lens barrel 23 of the projection optical system 300 are replaced with an inert gas in the projection exposure apparatus. As a result, the exposure light emitted by the light source 100 reaches the wafer W by traveling within the inert gas atmosphere. Thus, generation of ozone occurring due to photochemical reaction between the exposure light and air is prevented. Consequently, the environment is not polluted, the efficiency of the utilization of the exposure light (transmittance) is not reduced and the clouding that would otherwise occur at the surfaces of the optical elements such as the lenses 21 and the mirrors is prevented, thereby to achieve stable performance of the projection exposure apparatus.

In this projection optical system 300, the inert gas inside the lens barrel 23 can be collected and circulated in addition to replacing the atmosphere in the exposure light path with the inert gas so that the inert gas is utilized efficiently and without waste. In addition, when ArF excimer laser, for instance, is used as the exposure light, a problem occurs in that the transmittance of the projection optical system 300 varies even when the atmosphere inside the lens barrel 23 has been replaced with an inert gas. Namely, the adhesive or the filler material used to secure the lenses 21 at the holding members 22, foreign matter originating from the inner wall of the lens barrel 23 such as water and hydrocarbons or other substances that diffuse the exposure light become adhered to the lenses 21 or suspended within the light path whereby occurring the problem. However, by collecting the inert gas from the inside of the lens barrel 23 as explained above, fluctuations in the transmittance of the projection optical system can be minimized.

It is to be noted that the inert gas supplied into the space S1 at the uppermost position in the projection optical system 300 is then delivered into the plurality of other space S2, S3, S4,... through the communicating holes 25, 25 ... so that the atmosphere in the exposure light path can be replaced with the inert gas in the entire projection optical system 300. In this case, it is desirable to supply the inert gas first into the lowermost space and to discharge the inert gas from the uppermost space S1 when collecting the inert gas from the lens barrel 23 in a projection optical system whose optical axis is set along the vertical direction (the direction of gravity).

In the projection exposure apparatus as described above, when the lens distances between the lenses 21A and 21B and between the lenses 21C and 21D are adjusted by the adjustment units 30 and 40 respectively, since the sealing material 38, which is constituted of a viscous material, is retained between the side surfaces of the grooves 39 of the lower rings 36 and the side surfaces of the upper rings 37 and 47, a seal inside the lens chambers S1, S2, ... is achieved. Furthermore, the sealing material 38 becomes deformed readily in conformance to any relative displacement occurring between the lower rings 36 and the upper rings 37 and 47 along the direction of the optical axis. Thus a reaction force, which would offset the positional relationships between the lower rings 36 and the upper rings 37 and 47 along the direction perpendicular to the optical axis, does not generate. As a result, the positional relationship between the lenses 21A and 21B or the positional relationship between the lenses 21C and 21D of the adjustment unit 30 or 40 does not become offset due to adjustment thereby making it possible to achieve adjustments with a high degree of accuracy. Consequently, patterns can be overlaid with a high degree of accuracy on the wafer without causing any reduction in the accuracy of image formation at the projection exposure apparatus, i.e., without any fluctuation in the focal point position, the magnification factor and in Seidel's five aberrations at the projection optical system 300 or inducing any reduction in the telecentricity or the image contrast.

In addition, even when the volumetric capacities of the space S3 and S1 vary as a result of adjustments performed by the adjustment units 30 and 40, the gas pressure in the space S1 ∼ S4 are all maintained at the same level since the space S3 communicates with the space S4 and the space S1 communicates with the space S2. This, too, prevents any reduction in the projection accuracy at the projection exposure apparatus from occurring due to adjustments performed by the adjustment units 30 and 40 to realize a pattern overlay with a high degree of accuracy.

Instead of providing the adjustment unit 30 of the projection exposure apparatus, it is acceptable that only the lens 21D is can move relative to the lens 21C and 21E without varying the distance between the lenses 21C and 21E. Likewise, instead of providing the adjustment unit 40, it is acceptable that only the lens 21B can move relative to the lenses 21A and 21C without varying the distance between the lenses 21A and 21C.

It is to be noted that while the embodiment adopts a structure provided with the sealing portions 35 and 45 at the adjustment units 30 and 40 respectively, sealing portions such as those illustrated in FIG. 7 may be provided in place of the sealing portions 35 and 45.

As illustrated in FIG. 7, a sealing portion 55 at the adjustment unit 30 is constituted of a cylindrical member 56 that may be formed from, for instance, rubber, located over the external circumferential surface of the flange 31 at the upper end of the lower lens barrel 23A and the external circumferential surface of the flange 32 at the lower end of the upper lens barrel 23B. Likewise, a sealing portion 57 at the adjustment unit 40 is constituted of a cylindrical member 58 that may be formed from, for instance, rubber, located over the external circumferential surface of the flange 41 at the upper end of the upper lens barrel 23B and the external circumferential surface of the upper lid 23. In this seal structure, the cylindrical members 56 and 58 expand and contract along the direction of the optical axis during the adjustment of the distances between the optical elements.

In addition, by housing the entire projection optical system inside a chamber filled with an inert gas, the sealing portions 35 and 45 or 55 and 57 may be omitted. In this case, the inside of the chamber constitutes a gas chamber, and the gas chamber and the inside of the lens barrel 23 are communicated with each other through the communicating hole 43 at the upper lid 23C.

In the embodiment, the space S3 is communicated with the space S4 located on the opposite side across the lens 21D via the communicating holes 25 and the space S1 is communicated with the space S2 located on the opposite side across the lens 21B via the communicating holes 25. However, fluctuations in the pressure inside the lens chambers occurring when changing the distances between the lenses may be prevented in the following manner. Namely, through a communicating pipe instead of through communicating holes, the space S3 may be connected to a space S other than the space S4 and the space S1 likewise may be connected to a space S other than the space S2. Alternatively, the space S3 and S1 may be made to communicate with a container filled with an inert gas which is provided separately from the projection optical system 300. In this case, the space S1 and S2 or the space S3 and S4 should be made to communicate with the container.

In the above embodiment, the supply pipe 50 is provided at the lens barrel 23 of the projection optical system 300 to supply the inert gas through the supply pipe 50. However, when the reticle R is also housed inside a casing filled with an inert gas, the lens barrel 23 can be integrally connected to the casing. In the latter structure, the reticle casing may be linked with the lens barrel 23 via the communicating holes 43 to supply the inert gas from the reticle casing to the lens barrel 23 without providing the supply pipe 50.

It is also possible to discharge the inert gas through the opening 27 at the lower end of the lens barrel 23 without providing the discharge pipe 52.

In the structure of above embodiment, the present invention is applied to the projection optical system 300. However, the present invention may be adopted in other systems such as the illuminating optical system 200 and the light transmission system. In other words, the present invention can be adopted as described above at any portion in which two optical elements such as lenses or mirrors move relative to each other. For instance, the present invention can be adopted effectively in an illuminating optical system in which the illuminance distribution of the exposure light on the reticle R is adjusted by moving the fly-eye lens 204 as an optical integrator illustrated in FIG. 1 along the direction of the optical axis of the illuminating optical system to vary the distances between the optical integrator 204 and the two optical elements provided across the optical integrator 204.

In addition, in the projection optical system 300 in FIG. 6, when the lens 21C is moved by the adjustment unit 30, the lenses 21A and 21B stacked over the lens 21C are also caused to move. However, the mechanism employed to drive the lenses 21 is not restricted to this structural example and, for instance, a structure in which the holding members for the lenses 21A and 21B are not stacked above the holding member for the lens 21C and the lenses 21A and 21B do not move even when the holding member for the lens 21C is driven by the adjustment unit 30 may be adopted instead.

In place of the adjustment screws 33, three piezoelectric elements provided over equal angular intervals along the direction of the flange circumference, for instance, may be used to support the lens (or its holding member) and cause it to move. In addition, the number of lenses 21 that are capable of moving may be increased so that at least three of; the focal point position, the magnification factor, the distortion aberration, the astigmatism, the curvature of field, the coma aberration and the spherical aberration, can be adjusted.

The projection optical system 300 is provided with a plane parallel plate that is located on the side where the wafer W is present and can be inclined to correct the eccentric coma aberration and the present invention may be adopted in the drive mechanism employed to drive the plane parallel plate as well.

### (Seventh Embodiment)

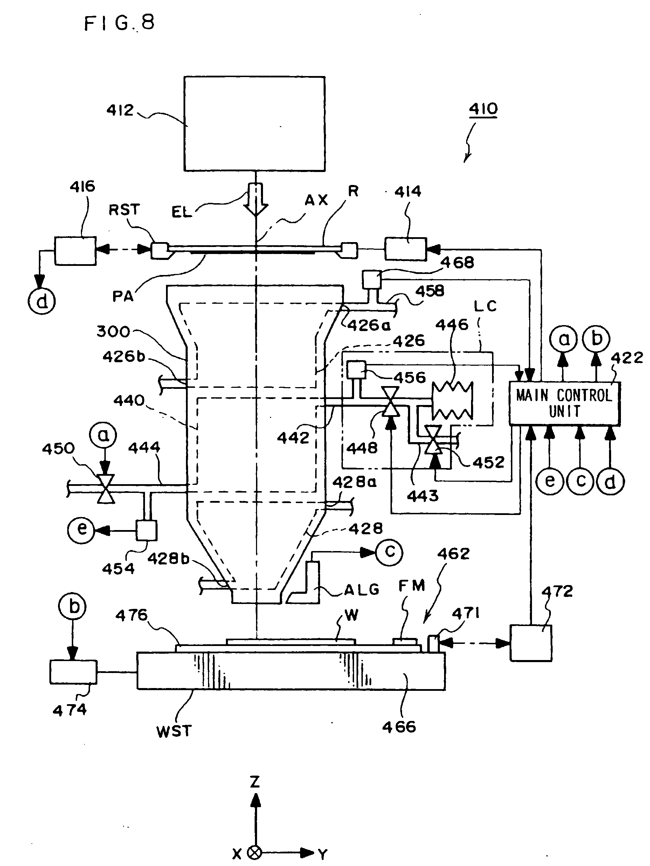

Now, an explanation is given on the seventh embodiment which implements control of the pressure within a space formed inside a projection optical system. FIG. 8 schematically illustrates the structure of an exposure apparatus 410 according to the embodiment. This exposure apparatus 410 is a scanning projection exposure apparatus (a so-called scanning stepper) that transfers a pattern formed on a reticle R as a mask onto a shot area on a wafer W as an object to be exposed via a projection optical system PL by adopting the step-and-scan method.

The exposure apparatus 410 comprises an illumination system 412 that includes a light source and irradiates exposure light EL as an illuminating beam onto the reticle R, a reticle stage RST on which the reticle R is mounted, the projection optical system PL that projects a pattern PA formed at the reticle R onto the wafer W, a pressure adjuster LC, which is referred to as a lens controller and increases / decreases the pressure inside a predetermined airtight chamber provided inside the projection optical system PL i.e., the pressure inside a sealed space 440, a wafer stage WST on which the wafer W is mounted, a control system that controls these components and the like.

The illumination system 412 includes the light source, i.e., an ArF excimer laser, an illuminating optical system that includes a shutter which opens / closes the light path and an optical integrator, i.e., a fly-eye lens, an illumination system aperture stop plate (revolver) and a blind that limits the illumination field for the illuminating light. At the illuminating optical system, the exposure light is made more even and speckles are reduced etc. Thus, the exposure light from the illumination system 412, i.e., the illuminating beam EL, is irradiated onto the reticle R mounted on the reticle stage RST which is to be detailed next, evenly and under predetermined illumination conditions.

The reticle R having the specific pattern PA formed thereon is mounted on the reticle stage RST. The reticle R is held by a reticle holder (not shown). The reticle stage RST is driven by a reticle stage drive system 414 constituted of a linear motor or the like along a scanning direction (the Y direction in this example) at a specific stroke and is capable of making fine movement within the X Y plane. The position of the reticle stage RST within the X Y plane is constantly detected by a reticle laser interferometer 416 at a specific degree of resolution of, for instance, approximately 0.5 ∼ 1nm, and the measurement value is supplied to a main control unit 422 that engages in overall control of the entire apparatus.

In the light path inside the projection optical system PL, unsealed space 426 and 428 each containing a plurality of lens elements and the airtight chamber 440 located between the lens elements are provided. The airtight chamber 440 is provided to adjust the image formation characteristics such as the projection magnification factor (or symmetrical distortion) through adjustment of the gas pressure inside the airtight chamber 440. The space 426 and 428 and the airtight chamber 440 are filled with nitrogen gas (N2) as is to be detailed later, and as a result, no ozone is generated inside the projection optical system PL even when exposure light (ArF laser light) is irradiated during an exposure operation which is also to be detailed later.

It is to be noted that the structure of the piping system through which the nitrogen gas is supplied to fill the space 426 and 428 and the airtight chamber 440, the method of filling the space and the chamber with the nitrogen gas and the structure of the pressure adjuster LC are to be explained in detail later.

The wafer stage WST comprises an X Y stage 466 positioned below the projection optical system PL, which is capable of making two-dimensional movement within a horizontal plane (the X Y plane) and a Z stage 476 mounted on the X Y stage 466, which is capable of making fine movement along the direction of the optical axis (the direction of the Z axis). A substrate, i.e., the wafer W is vacuum-held onto the Z stage 476 via a wafer holder (not shown), and the Z stage 476 is driven by a drive system to make fine movement along the direction of the optical axis. In addition, the X Y stage 466 is driven by a planar motor or the like along the X Y two-dimensional directions. In other words, while the wafer W is driven in the three-dimensional directions by the drive system for the Z stage 476 and the planar motor or the like that drives the X Y stage, these drive systems are represented by a wafer drive device 474 in FIG. 8.

The position of the X Y stage 466 is constantly detected by an external wafer laser interferometer 472 via a movable mirror 471 secured onto the X Y stage 466 or onto the Z stage 476 at a specific degree of resolution of, for instance, approximately 0.5 ∼ 1nm. The measurement value obtained by the wafer laser interferometer 472 is provided to the main control unit 422.

A reference mark plate FM on which a reference mark for baseline measurement and other reference marks are formed is secured onto the Z stage 476. The surface of the reference mark plate FM set at a height that is approximately the same as the height of the surface of the wafer W.

In the embodiment, an off-axis alignment microscope ALG that detects alignment marks on the wafer W, i.e. marks for positioning or the reference marks on the reference mark plate FM are provided at a side of the projection optical system PL toward the bottom. The alignment microscope ALG comprises an alignment sensor that implements image formation through image processing. The measurement value obtained by the alignment microscope ALG, too, is provided to the main control unit 422.

In addition, the exposure apparatus 410 is provided with a focal point detection mechanism (not shown) of the so-called oblique incident light type that detects the position of the surface of the wafer W along the direction of the optical axis (the direction of the Z axis) in order to align the surface of the wafer W with the focal position of the projection optical system PL.

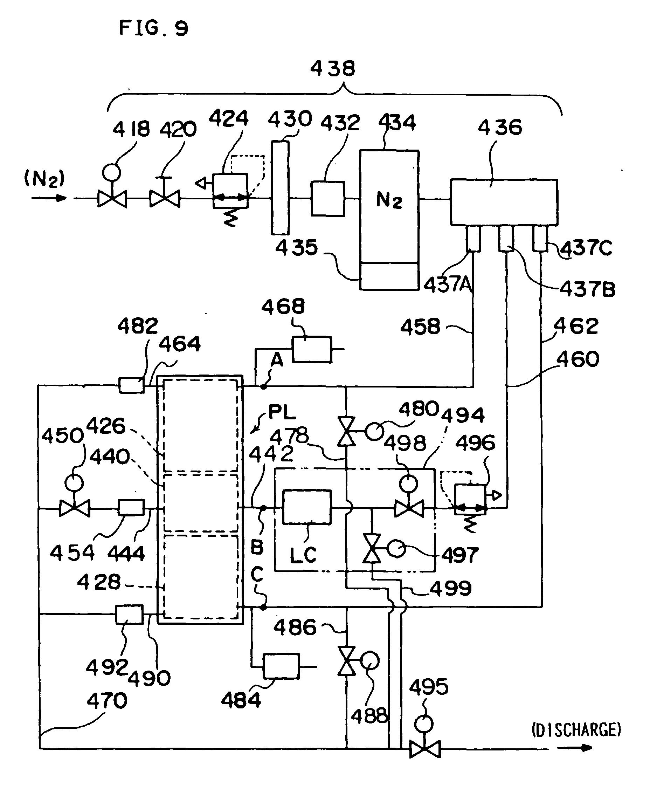

Next, a detailed explanation is given in reference to FIGS. 8 and 9 on the structural features that characterize the embodiment, i.e., the structure of the piping system through which the nitrogen gas is supplied to fill the space 426 and 428 and the airtight chamber 440 of the projection optical system PL, the structure of the pressure adjuster LC and the like.

FIG. 9 schematically illustrates the structure of the gas supply system employed to supply nitrogen gas (N2) into the projection optical system PL. This gas supply system comprises a gas supply device 438 comprising an electromagnetic valve 418, a manual valve 420, a first regulators 424, a flow meter 430, a filter unit 432, a buffer tank 434 and a distributor 436 that are sequentially connected to a nitrogen gas tank (not shown) constituting the supply source of the nitrogen gas via the piping system.

The electromagnetic valve 418 and the manual valve 420 are provided to allow / cut off inflow of the gas from the nitrogen gas tank (not shown) into the gas supply device 438. The first regulator 424 sets the supply pressure of the nitrogen gas supplied to first ∼ third supply pipes, to be detailed later, from the gas supply device 438. Although not shown, a pressure sensor that detects the internal pressure (gas pressure) inside the piping system near the first regulator 424 and a pressure meter that indicates the value detected by the pressure sensor are provided in the vicinity of the first regulator 424.

The filter unit 432 includes an air filter such as a ULPA filter (ultra low penetration air filter) or a HEPA filter (high efficiency particulate air filter), a chemical filter and the like. The chemical filter is employed to eliminate impurities that may form a clouding substance which would cloud mainly the lens elements and the like constituting the projection optical system PL.

The buffer tank 434 temporarily stores the nitrogen gas to achieve a temperature adjustment for the nitrogen gas to be supplied into the projection optical unit PL so that its temperature will be set approximately equal to the temperature of the air inside the projection optical system PL before the gas replacement. For this reason, a temperature adjustment device 435 is provided at the buffer tank 434. The target temperature to be achieved through the temperature adjustment is set approximately equal to the temperature inside the chamber in which the exposure apparatus 410 is housed, i.e., approximately equal to the temperature inside the clean room in which the chamber is installed.

The distributor 436 distributes the nitrogen gas having undergone the temperature adjustment into the three space inside the projection optical system PL i.e., the airtight chamber 440 at the center and the unsealed space 426 and 428 above and below the airtight chamber, and three flow-regulating valves 437A, 437B and 437C are provided on the outlet-side of the distributor 436.

A first supply pipe 458, a second supply pipe 460 and a third supply pipe 462 each as a supply passage are connected at one end thereof to the flow-regulating valves 437A, 437B and 437C respectively. The other end of the first supply pipe 458 is connected to the space 426 in the upper portion of the projection optical system PL. A discharge pipe 464 is connected to the side of the space 426 opposite from the side to which the first supply pipe 458 is connected. Further explanation will be made thereon detailedly as follows. As illustrated in FIG. 8, openings 426a and 426b are formed at heights different from each other at the space 426, in order to efficiently discharge the air in correspondence to its specific gravity relative to the gas supplied into the space 426 without allowing any air to remain in the upper portion of the space. While it is not crucial that this structure be adopted in the embodiment, in which nitrogen gas, which has a specific gravity approximately equal to that of air, is supplied, it is particularly effective when supplying other types of gas such as helium gas (He) into the space 426. The first supply pipe 458 is connected to the opening 426a at the space 426, and the discharge pipe 464, which constitutes part of the discharge passage and communicates with a main discharge pipe 470, is connected to the other opening 426b. In addition, as illustrated in FIGS. 8 and 9, a pressure detection system, i.e., a differential pressure sensor 468, is provided at the first supply pipe 458 near the opening 426a. The differential pressure sensor 468 detects the pressure in the space 426 relative to the atmospheric pressure by detecting the pressure difference between the atmospheric pressure, i.e., the pressure inside the chamber, and the pressure inside the first supply pipe 458 (approximately equal to the pressure in the space 426).

A branching passage communicating with the main discharge pipe 470, i.e., a first branching pipe 478, is provided at the first supply pipe 458 at a position slightly further toward the upstream side of the differential pressure sensor 468. An electromagnetic valve 480 as an open/close device is provided at the first branching pipe 478.

As illustrated in FIG. 9, a first oxygen sensor 482 is provided at the discharge pipe 464 near the opening 426b.

As explained above, the space 428 in the lower portion of the projection optical system PL is provided with openings 428a and 428b formed at heights different from each other, as illustrated in FIG. 8. And the other end of the third supply pipe 462 mentioned earlier is connected to the opening 428a. In addition, as illustrated in FIG. 9, a pressure detection system, i.e., a differential pressure sensor 484, is provided at the third supply pipe 462 near the opening 428a to detect the pressure in the space 428 relative to the atmospheric pressure by detecting the pressure difference between the atmospheric pressure, i.e., the pressure inside the chamber, and the pressure inside the third supply pipe 462 (approximately equal to the pressure in the space 428). A branching passage communicating with the main discharge pipe 470, i.e., a third branching pipe 486, is provided at the third supply pipe 462 at the slightly upstream side of the differential pressure sensor 484. An electromagnetic valve 488 as an open/close device is provided at the third branching pipe 486.

At the other opening 428b of the space 428, a discharge pipe 490 constituting part of the discharge passage and communicating with the main discharge pipe 470 is connected. A third oxygen sensor 492 is provided at the discharge pipe 490 near the opening 428b.

The other end of the second supply pipe 460 is connected to the airtight chamber 440 of the projection optical system PL via a pressure adjustment mechanism 494. A pressure setting device, i.e., a second regulator 496, is provided at the second supply pipe 460 at the upstream side of the pressure adjustment mechanism 494.

The pressure adjustment mechanism 494 comprises an electromagnetic valve 498 located at the downstream side of the second regulator 496, the pressure adjuster LC located at the downstream side of the electromagnetic valve 498 and an open/close device, i.e., an electromagnetic valve 497, located at a branching passage, i.e., located on a second branching pipe 499 branching at a position between the electromagnetic valve 498 and the pressure adjuster LC.

As illustrated in FIG. 8, the pressure adjuster LC comprises a bellows pump 446 connected to one end of a piping 442 (the piping 442 constitutes part of the supply passage) whose other end is connected to the airtight chamber 440, an electromagnetic valve 448 provide, on the piping 442, a pressure detection system, i.e., a differential pressure sensor 456, located at the downstream side of the electromagnetic valve 448 and an electromagnetic valve 452 located on a branching pipe 443 branching off the piping 442 at the upstream side of the electromagnetic valve 448. The nitrogen gas in the second supply pipe 460 is supplied via the electromagnetic valve 452.

As illustrated in FIGS. 8 and 9, a discharge pipe 444 communicating with the main discharge pipe 470 and constituting part of the discharge passage is connected to the discharge side of the airtight chamber 440. A discharge passage open/close device, i.e., an electromagnetic valve 450, is provided on the discharge pipe 444. A second oxygen sensor 454 is provided toward the airtight chamber 440 relative to the electromagnetic valve 450.

An electromagnetic valve 495 having a check valve is provided at the main discharge pipe 470 at the downstream side of the positions at which the first, second and third branching pipes 478, 499 and 486 are connected.

The measurement values obtained at the various sensors constituting the gas supply system structured as described above are provided to the main control unit 422 in FIG. 8 constituted of a work station (or a microcomputer). The main control unit 422 controls the various electromagnetic valves, the bellows pump and the like constituting the gas supply system based upon these measurement values, as detailed later.

Now, the procedure taken to replace the air inside the projection optical system PL of the exposure apparatus 410 structured as described above with nitrogen gas is briefly explained.

The manual valve 420 is manually opened in advance. The electromagnetic valve 418 is opened by the main control unit 422. The pressure setting at the first regulator 424 is set in advance to, for instance, 3kg/cm², so that nitrogen gas at 3kg/cm² is supplied into the buffer tank 434 from the nitrogen gas tank (not shown). At this point, the flow-regulating valves 437A ∼ 437C are all in a closed state, and when a specific length of time has elapsed, the distributor 436 is filled with nitrogen gas with its temperature adjusted to a predetermined level.

The main control unit 422 then opens the electromagnetic valve 498 on the supply side, the electromagnetic valves 448 and 452 inside the pressure adjuster LC and the electromagnetic valve 450 on the discharge side. At the same time, the main control unit 422 opens the flow-regulating valves 437A ∼ 437C. The pressure at the second regulator 496 is set in advance to, for instance, 2.5kg/cm² and the gas supply pressure in the supply pipe 460 is adjusted to a first value, i.e., 2.5kg/cm².

Thus, nitrogen gas supply into the space 426, the airtight chamber 440 and the space 428 at the projection optical system PL starts via the gas supply device 438, and more specifically, via the distributor 436 and the first ∼ third supply pipes 458, 460 and 462.

During the nitrogen gas supply, the main control unit 422 monitors the measurement values obtained by the first ∼ third oxygen sensors 482, 454 and 492, i.e., the oxygen gas concentrations within the discharge pipes 464, 444 and 490. At the same time, the main control unit 422 also monitors the measurement values obtained by the differential pressure sensor 468 ,456 and 484. While the air in the space 426, the airtight chamber 440 and the space 428 is being replaced by the nitrogen gas, the main control unit 422 waits for one of the oxygen concentrations detected by the first ∼ third oxygen sensors 482, 454 and 492 to become equal to or lower than a predetermined threshold value, e.g., 1%. For instance, if the oxygen concentration detected by the oxygen sensor 482 becomes equal to or lower than 1%, the main control unit 422 decides that the nitrogen gas replacement in the space 426 has been completed and, therefore, the space 426 is now filled with nitrogen gas, and displays information to this effect on a display device (not shown). However, if the detection value at the differential pressure sensor 468 becomes equal to or higher than a predetermined value during the nitrogen gas replacement (if the difference between the gas pressure inside the first supply pipe 458 and the atmospheric pressure becomes equal to or higher than a predetermined value), the main control unit 422 sets the electromagnetic valve 480 that opens / closes the first branching pipe 478 in an open state until the detection value at the differential pressure sensor 468 becomes lower than the predetermined value. Thus, any excess nitrogen gas is allowed to escape via the first branching pipe 478 to avoid a situation in which an abnormally high pressure affects the lens elements at the space 426 while supplying nitrogen gas to the space 426.

Likewise, if the oxygen concentration detected by the oxygen sensor 492 becomes equal to or lower than 1%, the main control unit 422 decides that the nitrogen gas replacement in the space 428 has been completed and, therefore, the space 428 is now filled with nitrogen gas, and displays information to this effect on the display device (not shown). Also, as described above, if the detection value at the differential pressure sensor 484 becomes equal to or higher than a predetermined value during the nitrogen gas replacement (if the difference between the gas pressure inside the third supply pipe 462 and the atmospheric pressure becomes equal to or higher than a predetermined value), the main control unit 422 sets the electromagnetic valve 488 that opens / closes the third branching pipe 486 in an open state until the detection value at the differential pressure sensor 484 becomes lower than the predetermined value, to avoid a situation in which an abnormally high pressure affects the lens elements at the space 428 while supplying nitrogen gas to the space 428.

When the nitrogen gas replacement as noted-above is completed, the flow-regulating valves 437A and 437C both remain in an open state, so that nitrogen gas is supplied into the space 426 and 428 at all times. Thus, the main control unit 422 should preferably implement open / close control on the electromagnetic valves 480 and 488 as necessary by constantly monitoring the detection values at the differential pressure sensor 468 and 484 to ensure that the lens elements located at the space 426 and 428 are not affected by an abnormally high pressure.

If the oxygen concentration detected by the oxygen sensor 454 becomes equal to or lower than 1%, the main control unit 422 decides that the nitrogen gas replacement inside the airtight chamber 440 has been completed and, therefore, the airtight chamber 440 is now filled with nitrogen gas, and displays information to this effect on the display device (not shown). At the same time, the main control unit 422 closes the electromagnetic valve 450 on the discharge side and the electromagnetic valve 498 on the supply side. While the pressure setting at the second regulator 496 is 2.5kg/cm² as explained earlier, the pressure adjuster LC is capable of operating at a second value, e.g., 1.0kg/cm² or lower. Thus, the electromagnetic valve 497 that opens / closes the second branching pipe 499 is opened to adjust the pressure at the airtight chamber 440 and at the pressure adjuster LC. In other words, the main control unit 422 monitors the measurement value at the differential pressure sensor 456 and allows any excess pressure to bleed off by opening the electromagnetic valve 497 until the gas pressure inside the piping 442 becomes equal to the second value. Then, when the gas pressure inside the piping 442 is equal to the second value, the main control unit 422 closes the electromagnetic valve 497 and also closes the electromagnetic valve 452 inside the pressure adjuster LC. Thus, nitrogen gas at 1.0kg/cm² or lower is supplied to fill the airtight chamber 420 and the pressure adjuster LC.

Consequently, a subsequent pressure adjustment inside the airtight chamber by the pressure adjuster LC is enabled at a supply pressure of 1kg/cm² or lower. During this process, if the detection value at the differential pressure sensor 456 becomes equal to or higher than a predetermined value within the above-noted nitrogen gas replacement, the main control unit 422 opens the electromagnetic valve 497 that opens / closes the second branching pipe 499 to ensure that the pressure inside the airtight chamber 440 does not become abnormally high.

Now, a brief explanation is given on the exposure processing operation that is performed when the air in the space 426 and 428 and the airtight chamber 440 of the projection optical system PL has been replaced by nitrogen, as described above.

The reticle R is delivered by a reticle delivery system (not shown) and becomes vacuum held onto the reticle stage RST at the loading position. Next, the main control unit 422 controls the positions of the wafer stage WST and the reticle stage RST, and any misalignment occurring between the reticle alignment marks (not shown) drawn on the reticle R and the reticle alignment reference marks on the reference mark plate FM is measured by a reticle microscope (not shown). In other words, reticle alignment is implemented.

Next, the main control unit 422 moves the wafer stage WST to position the reference marks for baseline measurement on the reference mark plate FM directly below the alignment microscope ALG. Based upon the detection signal provided by the alignment microscope ALG and the measurement value obtained by the wafer laser interferometer 472 at the corresponding time point, indirectly ascertained is the relative distance between the image formation position at which the image of the pattern at the reticle R is formed on the surface of the wafer W and the alignment microscope ALG, i.e., the baseline distance BL..

When the baseline measurement is completed, the main control unit 422 implements so-called EGA (enhanced global alignment) to ascertain error parameters (rotation, X Y scaling, X Y offset, orthogonality and the like) related to the shot array at the wafer W and also to ascertain the positions of all the shot areas on the wafer W.

Then, a step-and-scan exposure operation is performed in the following manner. The main control unit 422 positions the wafer stage WST at the first shot scanning start position in conformance to the positional information corresponding to the individual shot areas on the wafer W obtained as described above while monitoring the positional information from the laser interferometer 472, positions the reticle stage RST at the scanning start position and then performs scanning exposure of the first shot. During this scanning exposure operation, the main control unit 422 drives the reticle stage RST and the wafer stage WST in directions opposite from each other, controls the speeds of the two stages so that the ratio of the speeds of the stages accurately matches the projection magnification factor of the projection optical system PL and performs exposure (the reticle pattern transfer) in a state of uniform speed and synchronization while maintaining the specific speed ratio for the two stages.

When the scanning exposure of the first shot is completed as described above, the main control unit 422 engages in a stepping operation to move the wafer stage WST to the second shot scanning start position. Then, it performs scanning exposure of the second shot as described above. After this, the third shot and subsequent shots are exposed through a similar operation.

The shot-shot stepping operation and the shot scanning exposure operation are repeated in this manner, and the pattern at the reticle R is transferred onto all the shot areas on the wafer W through the step-and-scan method.

As the exposure processing operation described above is repeatedly performed while sequentially exchanging wafers W, the magnification factor of the projection optical system PL fluctuates due to fluctuations in the atmospheric pressure inside the chamber and the irradiation of the exposure light EL relative to the projection optical system PL during the repeated exposure processing operation. Accordingly, the main control unit 422 implements pressure control on the pressure inside the airtight chamber 440 via the pressure adjustment mechanism 494, mainly via the pressure adjuster LC) so as to cancel out such fluctuations measured or obtained through calculation on a regular basis, e.g., once for each specific number, i.e., so as to control the projection magnification factor at a specific value (e.g., 1/4 or 1/5 at all times. The pressure control inside the airtight chamber 440 is achieved in the following manner. Namely, the main control unit 422 drives the bellows pump 446 to cause it to expand and / or contract in a state in which the electromagnetic valve 452 is closed and the electromagnetic valve 448 is opened, thereby achieving pressure adjustment within the stroke range of the bellows pump 446.

If it becomes necessary to perform pressure adjustment outside the stroke range of the bellows pump 446, the main control unit 422 first closes the electromagnetic valve 448 and opens the electromagnetic valve 452 to supply nitrogen gas achieving a pressure level, equal to the second value (1.0kg/cm² or less) or equal to a value higher than the second value (the pressure may exceed 1.0kg/cm² if the control pressure within the airtight chamber 440 is controlled at a value exceeding 1.0kg/cm² through stroke control of the bellows pump 446) into the bellows pump 446 through the electromagnetic valve 498, and then drives the bellows pump 446 to achieve compression by closing the electromagnetic valve 452 and opening the electromagnetic valve 448. This operation is performed repeatedly. The above-noted gas supply to the pressure adjuster LC is adjusted by implementing open / close control of the electromagnetic valves 498 and 497 as necessary.

In more detail, if the control pressure inside the airtight chamber 440 is controlled at a value exceeding 1.0kg/cm² through stroke control implemented on the bellows pump 446 in order to achieve desired image formation characteristics through compensation, it is necessary to supply nitrogen gas with a pressure exceeding 1.0kg/cm² into the bellows pump 446 of the pressure adjuster LC. To achieve this, a pressure sensor (not shown) that detects the pressure in the pipeline between the
second regulator 496 and the electromagnetic valve 448 and pressure adjustment is performed as described below, after closing the electromagnetic valve 448 and opening the electromagnetic valve 498. Open / close control is implemented on the electromagnetic valve 497 while monitoring the pressure in the pipeline 443 with the pressure sensor (not shown). When the pressure in the pipeline 443 reaches a predetermined value detected at the differential pressure sensor 456, the electromagnetic valves 497 and 498 are closed. Through this process, gas with a pressure of a predetermined value exceeding 1.0kg/cm² is filled into the pressure adjuster LC. Thus, by driving the bellows pump 446 with the electromagnetic valve 448 set in an open state subsequently, the pressure in the airtight chamber 440 can be controlled at a desired level.

It is to be noted that in the above example, the gas pressure of 3.0kg/cm² adjusted by the first regulator 424 is lowered to 2.5kg/cm² by the second regulator 496 to replace the air in the airtight chamber 440 with nitrogen gas, and then nitrogen gas with its pressure adjusted to be equal to or lower than 1.0kg/cm² by the electromagnetic valve 497 is supplied to the pressure adjuster LC. However, according to the present invention, gas at an adjusted pressure does not need to be supplied to the pressure adjuster LC alone, and it may be supplied to other fluid devices.

As is obvious from the explanation given so far, the differential pressure sensor 468, the electromagnetic valve 480 and the main control unit 422 constitute a pipeline open/close device that opens the first branching pipe 478 when the pressure of the nitrogen gas (specific gas) exceeds a predetermined value, the differential pressure sensor 456, the electromagnetic valve 497 and the main control unit 422 constitute a pipeline open/close device that opens the second branching pipe 499 when the pressure of the nitrogen gas (specific gas) exceeds a predetermined value, and the differential pressure sensor 484, the electromagnetic valve 488 and the main control unit 422 constitute a pipeline open/close device that opens the third branching pipe 486 when the pressure of the nitrogen gas (specific gas) exceeds a predetermined value . In addition, the oxygen sensor 454 and the main control unit 422 constitute a gas filling level detection system that detects the degree to which the airtight chamber 440 is filled with gas in the embodiment.

Furthermore, the control device is realized as a function of the main control unit 422. The control device opens the corresponding electromagnetic valve 480, 497 or 488 when one of the pressure detected by the differential pressure sensor 468, 456 and 484 as the pressure detection system exceeds a predetermined value. Moreover, a first and a second control devices are both realized through functions of the main control unit 422. The first control device opens the electromagnetic valve 450 as the discharge passage open/close device, starts a gas supply from the gas supply device 438 at the gas supply pressure (supply side pressure) at the second supply pipe 460 via the pressure setting device constituted of the second regulator 496 set at the first value and the closed electromagnetic valve 497, closes the electromagnetic valve 450 and sets the gas supply pressure at the pressure adjuster LC to the second value lower than the first value through the electromagnetic valve 497 as the pressure setting device when the gas filling level detection system detects that the airtight chamber 440 has been filled with nitrogen gas. The second control device starts pressure control inside the airtight chamber 440 via the pressure adjustment mechanism 494 after the gas supply pressure is set to the second value. However, the present invention is not restricted to this example and it is obvious that the control device, the first control device and the second control device may be constituted by using separate hardware devices (computers and the like).

While the projection magnification factor is adjusted to maintain a specific value at all times in the explanation above, the present invention is not restricted to this example and the main control unit 422 may implement fine adjustment of the projection magnification factor in the non-scanning direction by controlling the pressure inside the airtight chamber 440 via the pressure adjuster LC based upon, for instance, the EGA XY scaling parameter mentioned earlier, in order to overlay the image of the pattern at the reticle R in the shot areas on the wafer W with an even higher degree of accuracy. In such a case, it is desirable to perform fine adjustment of the magnification factor along the scanning direction by adjusting the scanning speeds of the reticle stage RST and the wafer stage WST.

In addition, as is obvious from the explanation given above, the nitrogen gas in the space 426 is constantly refreshed in the embodiment in which nitrogen gas is constantly supplied into the space 426 and 428 during exposure processing. However, since nitrogen gas stagnates within the airtight chamber 440, impurities (impurities of an order that cannot be removed through a chemical filter or the like) contained in the nitrogen gas inside the airtight chamber 440 may form a clouding substance which then becomes adhered to the lens elements to cause a reduction in the transmittance of the projection optical system PL over time.

In order to deal with this concern, and also in order to ascertain any fluctuations of the magnification factor at the projection optical system PL resulting from irradiation of the exposure light EL, the transmittance of the projection optical system may be measured periodically (one every predetermined number of lots) so that nitrogen gas replacement is implemented anew inside the airtight chamber every time the results of the measurement of the transmittance indicate that the transmittance has become reduced to be equal to or lower than a predetermined threshold value. It is to be noted that it is desirable to provide chemical filters or the like at points A, B and C, and most importantly at point B in FIG. 9, in order to prevent the formation of a clouding substance.

No specific explanation has been given on the structure and the like of the discharge piping system located toward the downstream side relative to the electromagnetic valve 495 having a check valve. However, a chemical filter, for instance, may be provided at the trailing end of the discharge piping system to directly discharge exhaust gas having passed through the chemical filter into the atmosphere. It is obviously more desirable to recycle the nitrogen gas since it is more cost effective though.

Accordingly, a pump may be provided toward the downstream side of the electromagnetic valve 495 having a check valve, for instance, so that nitrogen gas can be recycled by connecting the pipeline toward the downstream side of the pump to the upstream side of the first regulator 424. In this case, since it is necessary to discharge the exhaust gas resulting from the initial nitrogen gas replacement to the outside, a branching passage may be provided between the electromagnetic valve 495 having a check valve and the pump, and an oxygen sensor and an electromagnetic valve are provided at the branching passage, so that exhaust gas is discharged through the branching passage to the outside by opening the electromagnetic valve until the concentration detected by the oxygen sensor becomes equal to or lower than a predetermined value and then the electromagnetic valve is closed to send exhaust gas (nitrogen gas) to the upstream side of the first regulator 424 with the pump for recycling.

While the explanation is given on an exposure apparatus utilizing an ArF excimer laser for its light source in the above embodiment, the present invention is not restricted to this example. The present invention can be preferably applied to apparatuses employing a beam source that emits an illuminating beam as the exposure light source, which can be utilized more efficiently by replacing the air inside the projection optical system with nitrogen gas or the like.

In addition, an explanation is given above on an example in which nitrogen gas is supplied to the projection optical system in the above embodiment, however, nitrogen gas may be supplied to a portion or the entirety of the illuminating optical system that irradiates an illuminating beam onto the mask, since similar advantages are achieved by replacing the air inside the illuminating optical system with nitrogen gas.

In the embodiment, the degrees to which the space 426 and 428 and the airtight chamber 440 are filled with nitrogen gas are detected based upon the concentrations of a specific gas, i.e., oxygen, within the discharge pipes 464, 444 and 490. As a result, the timing with which the spaces 426 and 428 and the airtight chamber 440 are filled with nitrogen gas can be detected with a high degree of reliability even when there are fluctuations in the pressure of the gas being supplied. Instead of oxygen, the concentration of nitrogen gas inside the discharge pipes 464, 444 and 490 may be directly detected. In addition, if the optical system is supplied with a specific gas other than nitrogen, the concentration of a gas constituting air, such as oxygen, nitrogen or the like or the concentration of the specific gas that is being supplied may be detected.

Alternatively, a timer or the like can be employed, as the gas filling level detection system that detects the degree to which the projection optical system PL or the airtight chamber 440 is filled with the specific gas, so that the passing of a predetermined length of time required for gas replacement after a start of supply of the specific gas may be detected. The predetermined length of time may be obtained in advance through testing.

While the pressure detection system is constituted of differential pressure sensor that are provided near the projection optical system PL in the embodiment, the present invention is not restricted to this example. For instance, differential pressure sensors, pressure sensors or the like that may be employed in the present invention can be positioned at any portion of the piping system as long as the ratios of the pressure in these portions with respect to the pressure inside the projection optical system PL or the pressure inside the pipeline in the vicinity are known. Alternatively, since the Boyle-Charles' law is applicable when a high degree of sealing is achieved as in the airtight chamber 440 and in such a case, the volume V can be assumed to be constant and, consequently, the pressure inside the airtight chamber can be assumed to be in proportion to the temperature inside the airtight chamber. Therefore, the pressure inside the airtight chamber may be indirectly detected based upon the output from a temperature sensor.

An explanation is given above in the individual embodiments on a prerequisite that the projection optical system is constituted of a plurality of refractive optical elements (lenses) alone. However, the present invention may be adopted in a projection optical system constituted of a plurality of reflective optical elements alone or a reflective / refractive optical system achieved through a combination of reflective optical elements and refractive optical elements.

It is desirable to supply nitrogen gas as an inert gas from the viewpoint of cost effectiveness in an exposure apparatus that uses ultraviolet light (such as an ArF excimer laser light) having a wavelength of approximately 190nm or greater as the exposure light. However, nitrogen gas should be supplied to the illuminating optical system and helium gas should be supplied to the projection optical system in an exposure apparatus whose projection optical system is a reflective / refractive optical system.

It is to be noted that in an exposure apparatus that uses ultraviolet light (FrF excimer laser light or the like) having a wavelength of approximately 200nm or larger as the exposure light, chemically clean dry air may be supplied to the illuminating optical system and the like instead of nitrogen or another inert gas. Such dry air may be achieved by removing ammonium ions and the like from the air inside the clean room through a chemical filter constituted of active charcoal or the like and adjusting its moisture content at a level equal to or less than, for instance, 5%. In addition, it is more realistic to supply a helium gas as an inert gas in an exposure apparatus that uses an ultraviolet light (F2 laser light or the like) having a wavelength of approximately 190nm or shorter.

The technology disclosed in the present invention may be adopted in a similar manner both in a step-and-repeat projection exposure apparatus and a step-and-scan projection exposure apparatus. In addition, a projection exposure apparatus is not restricted to that employed for semiconductor production, and the technology disclosed in the present invention may be widely adopted in, for instance, a projection exposure apparatus for liquid crystal device in which a rectangular glass plate is exposed with a liquid crystal display element pattern, an exposure apparatus employed to manufacture a thin film magnetic head and the like. Furthermore, the magnification factor at the projection optical system may be either no magnification or an enlarging system as well as a reducing system.

In addition, the light source that emits exposure light in a projection exposure apparatus is not restricted to an ArF excimer laser (193nm) and any of light sources that emit KrF excimer laser light (248nm), F2 laser light (157nm), harmonic of YAG laser light or metal vapor laser light and EUV (extreme ultraviolet) light having an oscillation spectrum over 5 ∼ 15nm (soft x-ray range) may be employed. In such a case, if an excimer laser is utilized, quartz or fluoride should be used as a optical material at the projection optical system. In addition, in an exposure apparatus that utilizes EUV light, the illumination area on a reflective type mask is formed to be an arc slit shape and a reducing projection optical system that is constituted of a plurality (four, for instance,) of reflecting optical elements (mirrors) is employed. And a pattern on the reflective type mask is transferred on the wafer by causing the reflective type mask and the wafer to move in synchronization with each other at the speed ratio that corresponds to the magnification factor at the reducing projection optical system. The principal ray of the EUV light is irradiated onto the reflective mask by inclining relative to the axis perpendicular to the reflective mask during this process.

A desired inert gas atmosphere may be created through an appropriate method in the space between the last lens in the projection optical system in FIG. 8 and the wafer. In more specific terms, an inert gas atmosphere may be created by enclosing the entire stage device on which the wafer is mounted inside a container (not shown) at the lower end of the projection optical system and filling the container with the inert gas or by continuously supplying the inert gas into the open space between the lower end of the projection optical system and the wafer.

It goes without saying that any other structures or combinations of the structural features described above may be adopted as long as they do not deviate from the scope and teaching of the present invention.

The exposure apparatus in each of the embodiments can be manufactured by performing optical adjustment with the illuminating optical system and the projection optical system each constituted of a plurality of lenses assembled into the exposure apparatus main body, by connecting wiring and piping after moving the reticle stage and the wafer stage each constituted of numerous mechanical parts at the exposure apparatus main body and by performing overall adjustment (electrical adjustment, operational verification and the like). It is desirable to manufacture the exposure apparatus in a clean room where the temperature, the degree of cleanness and the like are controlled.

In addition, the semiconductor device is manufactured through a step in which functions and performance of the device are designed, a step in which a reticle is prepared in conformance to the design decisions made in the design step, a step in which a wafer is produced from a silicon material, a step in which the wafer is exposed with a pattern at the reticle by the exposure apparatus in one of the embodiments explained earlier, a device assembly step (which includes a dicing process, a bonding process and a packaging process), an inspection step and the like.

## Claims

1. An exposure apparatus having an optical system that projects an image of a pattern on an original illuminated by exposure light emitted from an exposure light source onto an object to be exposed, comprising:
a gas supply device that fills a space formed between optical elements inside a housing member that houses said optical system with a specific gas;
a pressure sensor that detects pressure inside the space; and
an optical performance adjustment device that adjusts optical performance of said optical system in correspondence to the pressure detected by said pressure sensor.

2. An exposure apparatus according to claim 1, wherein:
said optical system includes a projection optical system that projects an image of the pattern at the original onto the object;
said housing member includes a lens barrel that houses said projection optical system;
said gas supply device includes a lens barrel gas supply device that fills a space formed between optical elements inside said lens barrel with the specific gas;
said pressure sensor includes a lens barrel internal pressure sensor that detects the pressure in the space inside said lens barrel; and
said optical performance adjustment device includes a projection optical performance adjustment device that adjusts the optical performance of said projection optical system.

3. An exposure apparatus according to claim 2, wherein:
said optical system includes an illuminating optical system that illuminates the original with the exposure light emitted by said exposure light source;
said housing member includes a casing that houses said illuminating optical system;
said gas supply device includes a casing gas supply device that fills a space formed between optical elements inside said casing with the specific gas;
said pressure sensor includes a casing internal pressure sensor that detects the pressure in the space inside said casing; and
said optical performance adjustment device includes an illumination optical performance adjustment device that adjusts the optical performance of said illuminating optical system.

4. An exposure apparatus according to claim 2, further comprising:
an atmospheric pressure sensor that detects atmospheric pressure, wherein:
said projection optical performance adjustment device adjusts the optical performance of said projection optical system based upon the pressure in the space within said lens barrel and the atmospheric pressure.

5. An exposure apparatus according to claim 3, further comprising:
an atmospheric pressure sensor that detects atmospheric pressure, wherein:
said illumination optical performance adjustment device adjusts the optical performance of said illuminating optical system based upon the pressure in the space within said casing and the atmospheric pressure.

6. An exposure apparatus according to claim 1, wherein:
said optical system includes an illuminating optical system that illuminates the original with the exposure light emitted by said exposure light source,
said housing member includes a casing that houses said illuminating optical system;
said gas supply device includes a casing gas supply device that fills a space formed between optical elements inside said casing with the specific gas;
said pressure sensor includes a casing internal pressure sensor that detects the pressure in the space inside said casing; and
said optical performance adjustment device includes an illumination optical performance adjustment device that adjusts the optical performance of said illuminating optical system.

7. An exposure apparatus according to claim 6, further comprising:
an atmospheric pressure sensor that detects atmospheric pressure, wherein:
said illumination optical performance adjustment device adjusts the optical performance of said illuminating optical system based upon the pressure in the space within said casing and the atmospheric pressure.

8. An exposure apparatus according to claim 1, wherein:
said optical performance adjustment device is provided with a pressure adjustment mechanism that adjusts the pressure in the space formed between the optical elements.

9. An exposure apparatus according to claim 1, wherein:
a plurality of optical elements are provided to form the space inside said housing member and said optical performance adjustment device is provided with a moving mechanism that causes, at least, a first optical element among said plurality of optical elements to move relative to a second optical element along a specific direction.

10. An exposure apparatus having an optical system that projects an image of a pattern on an original illuminated by exposure light emitted from an exposure light source onto an object to be exposed, comprising:
a gas supply device that fills a space formed between optical elements inside a housing member that houses said optical system with a specific gas;
a pressure sensor that detects pressure inside the space; and
a pressure adjustment device that adjusts the pressure in the space in correspondence to the pressure detected by said pressure sensor so as to ensure that the pressure in the space achieves a predetermined target value.

11. An exposure apparatus according to claim 10, wherein:
said optical system includes a projection optical system that projects an image of the pattern at the original onto the object;
said housing member includes a lens barrel that houses said projection optical system;
said gas supply device includes a lens barrel gas supply device that fills a space formed between optical elements inside said lens barrel with the specific gas;
said pressure sensor includes a lens barrel internal pressure sensor that detects the pressure in the space inside said lens barrel; and
said pressure adjustment device includes a lens barrel internal pressure adjustment device that adjusts said lens barrel gas supply device so as to ensure that the pressure in the space within said lens barrel achieves a predetermined target value.

12. An exposure apparatus according to claim 11, wherein:
said optical system includes an illuminating optical system that illuminates the original with the exposure light emitted from said exposure light source;
said housing member includes a casing that houses said illuminating optical system;
said gas supply device includes a casing gas supply device that fills a space formed between optical elements inside said casing with the specific gas;
said pressure sensor includes a casing internal pressure sensor that detects the pressure in the space inside said casing; and
said pressure adjustment device includes a casing internal pressure adjustment device that adjusts said casing gas supply device so as to ensure that the pressure in the space within said casing achieves a predetermined target value.

13. An exposure apparatus according to claim 11, further comprising:
an atmospheric pressure sensor that detects atmospheric pressure; and
a projection optical performance adjustment device that adjusts the optical performance of said projection optical system in correspondence to the pressure detected by said atmospheric pressure sensor.

14. An exposure apparatus according to claim 12, further comprising:
an atmospheric pressure sensor that detects atmospheric pressure; and
an illumination optical performance adjustment device that adjusts the optical performance of said illuminating optical system in correspondence to the pressure detected by said atmospheric pressure sensor.

15. An exposure apparatus according to claim 10, wherein:
said optical system includes an illuminating optical system that illuminates the original with the exposure light emitted by said exposure light source;
said housing member includes a casing that houses said illuminating optical system;
said gas supply device includes a casing gas supply device that fills a space formed between optical elements inside said casing with the specific gas;
said pressure sensor includes a casing internal pressure sensor that detects the pressure in the space inside said casing; and
said pressure adjustment device includes a casing internal pressure adjustment device that adjusts said casing gas supply device so as to ensure that the pressure in the space within said casing achieves a predetermined target value.

16. An exposure apparatus according to claim 15, further comprising:
an atmospheric pressure sensor that detects atmospheric pressure, and
an illumination optical performance adjustment device that adjusts the optical performance of said illuminating system in correspondence to the pressure detected by said atmospheric pressure sensor.

17. An exposure apparatus according to claim 7, wherein:
said optical performance adjustment device is provided with a first holding member that holds the one of optical elements and a second holding member that holds the other optical element,
a sealing portion that prevents the specific gas from flowing out through the space formed between the optical elements is provided between said first holding member and said second holding member; and
said sealing portion comprises an indented portion formed at the side of first holding member, a projected portion formed toward said second holding member that is inserted inside said indented portion and a filler material having a sealing property that is filled the space between said indented portion and said projected portion.

18. An exposure apparatus according to claim 17, wherein:
said filler material is constituted of an inert grease that remains photochemically inert.

19. An exposure apparatus according to claim 18, wherein:
said optical performance adjustment device is provided at, at least, either said projection optical system or said illuminating optical system.

20. An exposure apparatus according to claim 9, wherein:
said gas supply device supplies the specific gas to a first space among a plurality of space enclosed between said plurality of optical elements constituting said optical system, said first space being formed between said second optical element and a third optical element and being not in contact with said first optical element; and
a second space enclosed between the first optical element and second optical element is communicated with said first space by a means for communication.

21. An exposure apparatus according to claim 20, wherein:
said means for communication is constituted of a communicating hole provided at said holding member that holds said second optical element.

22. An exposure apparatus according to claim 20, wherein:
said first space is sealed by a filler material provided at a linking portion at which a movable member that holds said first optical element and a main body of said projection optical system are linked.

23. An exposure apparatus according to claim 8, comprising:
a supply passage that is provided separately from a discharge passage connected to said optical system, connects said gas supply device to said optical system, and is provided with a branching passage at a portion between said gas supply device and said optical system; and
a pipeline open/close device that opens said branching passage when the pressure of the specific gas exceeds a predetermined value.

24. An exposure apparatus according to claim 23, wherein:
said pipeline open/close device comprises;
a pressure detection system that either directly or indirectly detects the internal pressure at said optical system;
an open/close devise that opens/closes said branching passage; and
a control device that opens said open/close devise when the pressure detected by said pressure detection system exceeds a predetermined value.

25. An exposure apparatus according to claim 8, wherein:
said pressure adjustment mechanism increases or decreases the pressure in the space and is provided in the middle of a supply passage connecting the space to said gas supply device;
said exposure apparatus further comprising;
a discharge passage open/close device that opens / closes a discharge passage connected to the space;
a gas filling level detection system that detects whether or not the space has been filled with the specific gas;
a pressure setting device that sets a gas supply pressure inside said supply passage;
a first control device that opens said discharge passage open/close device and sets the gas supply pressure at a first value via said pressure setting device before said gas supply device starts to supply the specific gas, and that close said discharge passage open/close device and sets the gas supply pressure to a second value lower than the first value via said pressure setting device when said gas filling level detection system detects that the space has been filled with the specific gas; and
a second control device that starts to implement pressure control in the space via said pressure adjustment mechanism after the gas supply pressure is set to the second value.

26. An exposure apparatus according to claim 25, wherein:
said gas filling level detection system detects the degree to which said optical system has been filled with the specific gas based upon a concentration of a specific gas inside said optical system or inside said discharge passage.

27. An exposure method for projecting an image of a pattern on an original illuminated by exposure light emitted from an exposure light source onto an object to be exposed, comprising steps of:
filling a space formed between optical elements inside a housing member that houses said optical system with a special gas;
detecting the pressure in the space; and
adjusting the optical performance of said optical system in correspondence to the pressure detected by said pressure sensor.

28. An exposure apparatus that exposes a substrate with an illuminating beam via a mask, comprising:
a gas supply device that supplies a specific gas to an optical system provided in a light path of the illuminating beam;
a supply passage that is provided separately from a discharge passage connected to said optical system, connects said gas supply device to said optical system and is provided with a branching passage at a portion between said gas supply device and said optical system; and
a pipeline open/close device that opens said branching passage when the pressure of the specific gas exceeds a predetermined value.

29. An exposure method for exposing a substrate with an illuminating beam via a mask, comprising steps of:
supplying a specific gas to an optical system provided in a light path of the illuminating beam; and
opening a branching passage when the pressure of the specific gas exceeds a predetermined value, said branching passage being provided separately from a discharge passage connected to said optical system and connecting said gas supply device to said optical system.

30. An exposure apparatus that transfers a pattern on a mask onto a substrate via a projection optical system, comprising:
said projection optical system having an airtight chamber provided, at least, at a portion of said projection optical system;
a gas supply device that supplies a specific gas to said airtight chamber;
a discharge passage open/close device that opens / closes a discharge passage connected to said airtight chamber;
a gas filling level detection system that detects whether or not said airtight chamber has been filled with the specific gas;
a pressure adjustment mechanism provided in the middle of a supply passage connecting said airtight chamber to said gas supply device that increases or decreases the pressure in said airtight chamber;
a pressure setting device that sets a gas supply pressure inside said supply passage;
a first control device that opens said discharge passage open/close device and sets the gas supply pressure at a first value via said pressure setting device before said gas supply device starts to supply the specific gas and that closes said discharge passage open/close device and sets the gas supply pressure to a second value lower than the first value via said pressure setting device when said gas filling level detection system detects that said airtight chamber has been filled with the specific gas; and
a second control device that starts pressure control in said airtight chamber via said pressure adjustment mechanism after the gas supply pressure is set to the second value.

31. A method of, with a pressure adjustment mechanism, adjusting an internal pressure of an airtight chamber inside a projection optical system to adjust image formation characteristics of said projection optical system, comprising steps of:
starting supply of a specific gas to said airtight chamber after a discharge passage connected to said airtight chamber is opened and a gas supply pressure is set at a first value, before start of pressure control inside said airtight chamber,
setting the gas supply pressure at a second value that is lower than the first value and is within a range that allows said pressure adjustment mechanism to operate after said discharge passage is closed, when said airtight chamber has been filled with the specific gas.

32. A method of assembling an exposure apparatus having an optical system that projects an image of a pattern on an original illuminated by exposure light emitted from an exposure light source onto an object to be exposed, comprising steps of:
connecting a gas supply device that fills a space formed between optical elements inside a housing member that houses said optical system with a specific gas to the space;
providing a pressure sensor that detects the pressure in the space within the space; and
providing an optical performance adjustment device that adjusts the optical performance of said optical system in correspondence to the pressure detected by said pressure sensor at said optical system.

33. A method of assembling an exposure apparatus that exposes a substrate with an illuminating beam via a mask, comprising steps of:
connecting a gas supply device that supplies a specific gas to an optical system provided in a light path of the optical beam;
connecting said gas supply device and said optical system to a supply passage provided separately from a discharge passage connected to said optical system, and
providing a branching passage in the middle of said supply passage; and
opening a pipeline open/close device that opens said branching passage when the pressure of the specific gas exceeds a predetermined value.
